# EUROPEAN PATENT APPLICATION

(11) **EP 4 436 336 A1**
(43) Date of publication of application: **25.09.2024**
(21) Application number: 22895771.8
(22) Date of filing: 20.06.2022
(51) Int. Cl.: H10K 59/00, H01L 29/786

(54) **DISPLAY DEVICE**

(30) Priority: 18.11.2021 KR 20210159513
(71) Applicant: Samsung Display Co., Ltd., Yongin-si, Gyeonggi-do 17113 (KR)
(72) Inventor: KIM, Keun Woo, Yongin-si, Gyeonggi-do 17113 (KR)
(74) Representative: Marks & Clerk LLP
(86) International application number: PCT/KR2022/008712
(87) International publication number: WO 2023/090559

(57) **Abstract**

A display device includes: a substrate; a buffer layer on the substrate; a driving transistor on the buffer layer and including a first semiconductor pattern, a first gate electrode, a first source electrode, and a first drain electrode; and a switching transistor on the buffer layer and spaced apart from the driving transistor, the switching transistor including a second semiconductor pattern, a second gate electrode, a second source electrode, and a second drain electrode, wherein the buffer layer includes a first buffer layer including silicon nitride and a second buffer layer including silicon oxide, only the second buffer layer is under the first semiconductor pattern of the driving transistor, and the first buffer layer and the second buffer layer are under the second semiconductor pattern of the switching transistor.

## Description

### Technical Field

Aspects of some embodiments of the present invention relate to a display device.

### Background Art

With the development of information technology, the importance of display devices, which are a connection medium between a user and information, has been highlighted.

A display device includes a plurality of pixels. Each of the pixels generally includes a plurality of transistors, a light emitting element electrically connected to the transistors, and a capacitor. The transistors are respectively turned on in response to signals provided through lines, and a driving current may be generated accordingly. The light emitting element emits light in response to the driving current.

Recently, in order to improve the driving efficiency of the display device and reduce power consumption of the display device, a method of driving the display device at a relatively low frequency may be used. Therefore, there may be a need for a method capable of improving display quality in response to the display device being driven at a relatively low frequency.

### Detailed Description of Invention

### Technical Problem

An object of the present invention is to provide a display device capable of reducing a leakage current (or an off current) of a switching transistor when the display device is driven at a low frequency, and increasing a driving range (hereinafter, a DR range) of a gate voltage applied to a gate electrode of a driving transistor.

### Technical Solution

A display device includes: a substrate; a buffer layer on the substrate; a driving transistor on the buffer layer and including a first semiconductor pattern, a first gate electrode, a first source electrode, and a first drain electrode; and a switching transistor on the buffer layer and spaced apart from the driving transistor, the switching transistor including a second semiconductor pattern, a second gate electrode, a second source electrode, and a second drain electrode.

The buffer layer includes a first buffer layer including silicon nitride and a second buffer layer including silicon oxide, only the second buffer layer is under the first semiconductor pattern of the driving transistor, and the first buffer layer and the second buffer layer are under the second semiconductor pattern of the switching transistor.

The first semiconductor pattern and the second semiconductor pattern may include polysilicon.

A hydrogen ion concentration included in the second semiconductor pattern may be greater than a hydrogen ion concentration included in the first semiconductor pattern.

A first thickness of the second buffer layer under the first semiconductor pattern may be substantially equal to a second thickness of the second buffer layer under the second semiconductor pattern.

A third thickness of the first buffer layer under the second semiconductor pattern may be less than the second thickness.

A first thickness of the second buffer layer under the first semiconductor pattern may be equal to a sum of a second thickness of the second buffer layer under the second semiconductor pattern and a third thickness of the first buffer layer under the second semiconductor pattern.

The display device may further include a barrier layer including silicon oxide between the substrate and the buffer layer.

The first buffer layer may be on the barrier layer, and the second buffer layer may be on the first buffer layer.

A plurality of pixels may be on the substrate, and each of the pixels may include: a light emitting element; the driving transistor connected between a first power supply and a second node and controlling a driving current supplied to the light emitting element in response to a voltage of a first node connected to the first gate electrode; a first capacitor including one electrode connected to the first node and the other electrode connected to a third node; a second transistor connected between the third node and a data line and turned on by a first scan signal; a third transistor connected between the first node and the second node and turned on by a second scan signal; a fourth transistor connected between the first node and an initialization power supply and turned on by a third scan signal; and a fifth transistor connected between a reference power supply and the third node and turned on by the second scan signal.

The second transistor may include a (2_1)th transistor and a (2_2)th transistor connected in series, the third transistor may include a (3_1)th transistor and a (3_2)th transistor connected in series, the fourth transistor may include a (4_1)th transistor and a (4_2)th transistor connected in series, and the fifth transistor may include a (5_1)th transistor and a (5_2)th transistor connected in series.

The switching transistor may include the second transistor, the third transistor, the fourth transistor, and the fifth transistor.

The display device may further include: a sixth transistor connected between the first power supply and a fifth node connected to one electrode of the driving transistor and turned on by a first emission control signal; a seventh transistor connected between the second node and a fourth node and turned on by a second emission control signal; an eighth transistor connected between the fourth node and an anode initialization power supply and turned on by a fourth scan signal; and a ninth transistor connected between the fifth node and a bias power supply and turned on by the fourth scan signal.

The display device may further include a second capacitor including one electrode connected to the first power supply and the other electrode connected to the third node.

A display device includes: a substrate; a buffer layer on the substrate; a driving transistor on the buffer layer and including a first semiconductor pattern, a first gate electrode, a first source electrode, and a first drain electrode; and a switching transistor on the buffer layer and spaced apart from the driving transistor, the switching transistor including a second semiconductor pattern, a second gate electrode, a second source electrode, and a second drain electrode.

The buffer layer includes a first buffer layer including silicon nitride and a second buffer layer including silicon oxide, the first buffer layer and the second buffer layer are under the first semiconductor pattern of the driving transistor, the first buffer layer and the second buffer layer are under the second semiconductor pattern of the switching transistor, and a first thickness of the second buffer layer under the first semiconductor pattern is greater than a second thickness of the second buffer layer under the second semiconductor pattern.

The first semiconductor pattern and the second semiconductor pattern may include polysilicon.

A hydrogen ion concentration included in the second semiconductor pattern may be greater than a hydrogen ion concentration included in the first semiconductor pattern.

A third thickness of the first buffer layer may be less than the first thickness and the second thickness.

The display device may further include a barrier layer including silicon oxide between the substrate and the buffer layer.

The first buffer layer may be on the barrier layer, and the second buffer layer may be on the first buffer layer.

The second drain electrode may be electrically connected to the first gate electrode.

### Advantageous Effects

In a display device according to an embodiment of the present invention, the types and/or thicknesses of the buffer layers located under the semiconductor layers of the switching transistor and the driving transistor may be differently formed, thereby reducing the leakage current of the switching transistor and increasing the driving range of the driving transistor.

### Description of Drawings

FIG. 1 is a block diagram illustrating a display device according to some embodiments of the present invention.
FIG. 2 is a circuit diagram illustrating a pixel according to some embodiments of the present invention.
FIGS. 3A to 3F are waveform diagrams for describing the operation of the pixel of FIG. 2 during a display scan period according to some embodiments of the present invention.
FIGS. 4A to 4D are waveform diagrams for describing the operation of the pixel of FIG. 2 during a self-scan period according to some embodiments of the present invention.
FIG. 5 is a conceptual diagram for describing an example of a method of driving a display device according to an image refresh rate.
FIG. 6A is a schematic plan view of a plurality of pixels, when seen from above based on the pixel of FIG. 2.
FIG. 6B is a plan view illustrating an example of a semiconductor layer included in the pixel of FIG. 6A.
FIG. 6C is a plan view illustrating an example of a first conductive layer included in the pixel of FIG. 6A.
FIG. 6D is a plan view illustrating an example of a second conductive layer included in the pixel of FIG. 6A.
FIG. 6E is a plan view illustrating an example of a third conductive layer included in the pixel of FIG. 6A.
FIG. 6F is a plan view illustrating an example of a fourth conductive layer included in the pixel of FIG. 6A.
FIG. 7 is a partial cross-sectional view for describing a stack structure of a first transistor area, a third transistor area, and a seventh transistor area of FIG. 6A according to some embodiments of the present invention.
FIG. 8 is a graph showing a trade-off relationship between leakage current characteristics and a driving range.
FIG. 9 is a partial cross-sectional view for describing a stack structure of a first transistor area, a third transistor area, and a seventh transistor area of FIG. 6A according to some embodiments of the present invention.
FIGS. 10A to 10C are diagrams for describing a method of forming a buffer layer in the embodiments of FIGS. 7 and 9.
FIG. 11 is a schematic plan view for describing a position of a photoresist pattern.
FIG. 12 is a partial cross-sectional view for describing a stack structure of a first transistor area, a third transistor area, and a seventh transistor area of FIG. 6A according to some embodiments of the present invention.
FIGS. 13A and 13B are diagrams for describing a method of forming a buffer layer in the embodiments illustrated with respect to FIG. 12.
FIG. 14 is a schematic plan view for describing a position of a photoresist pattern according to some embodiments of the present invention.

### Modes of the Invention

As the present description allows for various changes and numerous embodiments, certain embodiments will be illustrated in the drawings and described in detail in the written description. However, this is not intended to limit the present invention to a specific form disclosed herein, and it should be understood that the present invention includes all changes, equivalents, and substitutes falling within the spirit and scope of the present invention.

In describing each drawing, similar reference numerals are used for similar elements. In the accompanying drawings, the dimensions of the structures are exaggerated for clarity of the present invention. While such terms as "first" and "second" may be used to describe various elements, such elements must not be limited by the above terms. The above terms are used to distinguish one element from another. For example, while not departing from the scope of the present invention, a first element may be referred to as a second element, and similarly, a second element may be referred to as a first element. The singular forms "a," "an," and "the" as used herein are intended to include the plural forms as well unless the context clearly indicates otherwise.

The terms "comprises," "comprising," "including," and "having," as used in this application are inclusive and therefore specify the presence of stated features, integers, steps, operations, elements, or components, but do not preclude the presence or addition of one or more other features, integers, steps, operations, elements, components, or combinations thereof.

It will be understood that when a region is referred to as being "connected to" or "coupled to" another region, it may be directly connected or coupled to the other region or intervening regions may be present.

Hereinafter, embodiments of the present invention will be described in more detail with reference to the accompanying drawings.

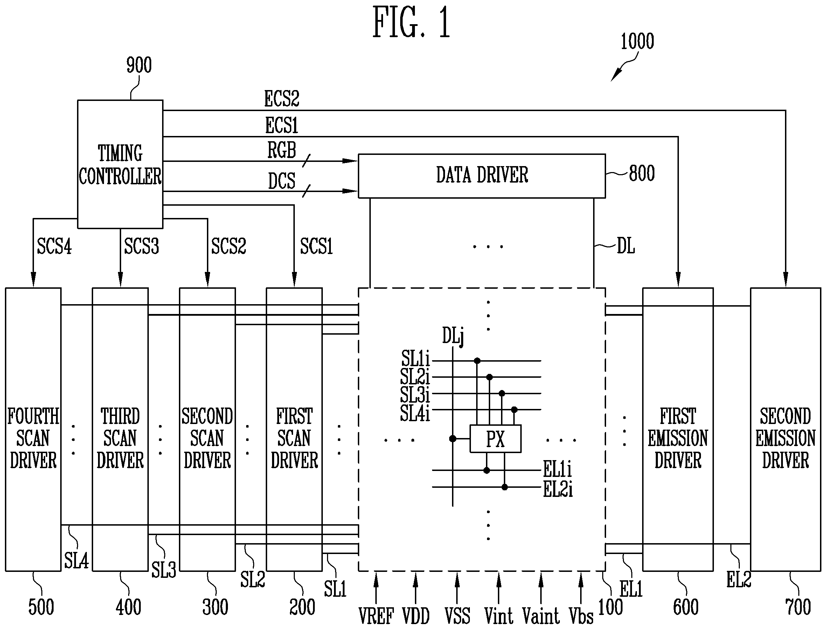

FIG. 1 is a block diagram illustrating a display device according to embodiments of the present invention.

Referring to FIG. 1, a display device 1000 may include a display panel 100, scan drivers 200, 300, 400, and 500, emission drivers 600 and 700, a data driver 800, and a timing controller 900.

The scan drivers 200, 300, 400, and 500 may be divided into the configurations and operations of a first scan driver 200, a second scan driver 300, a third scan driver 400, and a fourth scan driver 500. The emission drivers 600 and 700 may be divided into the configurations and operations of a first emission driver 600 and a second emission driver 700. However, the distinction between the scan driver and the emission driver is for convenience of description, and at least a portion of the scan driver and the emission driver may be integrated into a single driving circuit, module, or the like according to the design.

According to some embodiments, the display device 1000 may further include a power supply for supplying a voltage of a first power supply VDD, a voltage of a second power supply VSS, a voltage of a third power supply VREF (or a reference power supply), a voltage of a fourth power supply Vint (or an initialization power supply), a voltage of a fifth power supply Vaint (or, an anode initialization power supply), and a voltage of a sixth power supply Vbs (or a bias power supply) to the display panel 100. The power supply may supply, to the scan drivers 200, 300, 400, and 500 and/or the emission drivers 600 and 700, a voltage of a low power supply and a voltage of a high power supply for determining a gate-on level and a gate-off level of a scan signal, a control signal, and/or an emission control signal. The voltage of the low power supply may have a relatively lower voltage level than the voltage of the high power supply. However, this is only an example, and at least one of the voltages of the first power supply VDD, the second power supply VSS, the third power supply VREF (or the reference power supply), the fourth power supply Vint (or the initialization power supply), the fifth power supply Vaint (or the anode Initialization power supply), the sixth power supply Vbs (or the bias power supply), the low power supply, and the high power supply may be supplied from the timing controller 900 or the data driver 800.

According to some embodiments, the first power supply VDD and the second power supply VSS may generate voltages for driving the light emitting element. According to some embodiments, the voltage level of the second power supply VSS may be lower than the voltage level of the first power supply VDD. For example, the voltage of the first power supply VDD may be a positive voltage, and the voltage of the second power supply VSS may be a negative voltage.

The reference power supply VREF may be a power supply for initializing the pixel PX. For example, a capacitor and/or a transistor included in the pixel PX may be initialized by the voltage of the reference power supply VREF. The reference power supply VREF may generate a positive voltage.

The initialization power supply Vint may be a power supply for initializing the pixel PX. For example, the driving transistor included in the pixel PX may be initialized by the voltage of the initialization power supply Vint. The initialization power supply Vint may generate a negative voltage.

The anode initialization power supply Vaint may be a power supply for initializing the pixel PX. For example, the anode of the light emitting element included in the pixel PX may be initialized by the voltage of the initialization power supply Vaint. The initialization power supply Vint may generate a negative voltage.

The bias power supply Vbs may be a power supply for supplying an on-bias voltage (e.g., a set or predetermined on-bias voltage) to a source electrode of the driving transistor included in the pixel PX. The bias power supply Vbs may generate a positive voltage. According to some embodiments, the voltage of the bias power supply Vbs may be at a level similar to a data voltage of a black grayscale. For example, the voltage of the bias power supply Vbs may be about 5 V to 7 V.

The display device 1000 may display an image at various image refresh rates (driving frequencies or screen refresh rates) according to driving conditions. The image refresh rate is the frequency at which the data signal is substantially written to the driving transistor of the pixel PX. For example, the image refresh rate is also referred to as a screen scan rate or a screen refresh rate, and represents the frequency at which the display screen is refreshed for 1 second.

According to some embodiments, an output frequency of the data driver 800 for one horizontal line (or pixel row) and/or an output frequency of the first scan driver 200 that outputs a write scan signal may be determined according to the image refresh rate. For example, a refresh rate for driving a moving picture may be a frequency of about 60 Hz or more (e.g., 120 Hz).

According to some embodiments, the display device 1000 may control the output frequencies of the scan drivers 200, 300, 400, and 500 for one horizontal line (or pixel rows) and the corresponding output frequencies of the data driver 800 according to the driving conditions. For example, the display device 1000 may display images corresponding to various image refresh rates ranging from 1 Hz to 120 Hz. However, this is only an example, and the display device 1000 may display images even at an image refresh rate of 120 Hz or higher (e.g., 240 Hz or 480 Hz).

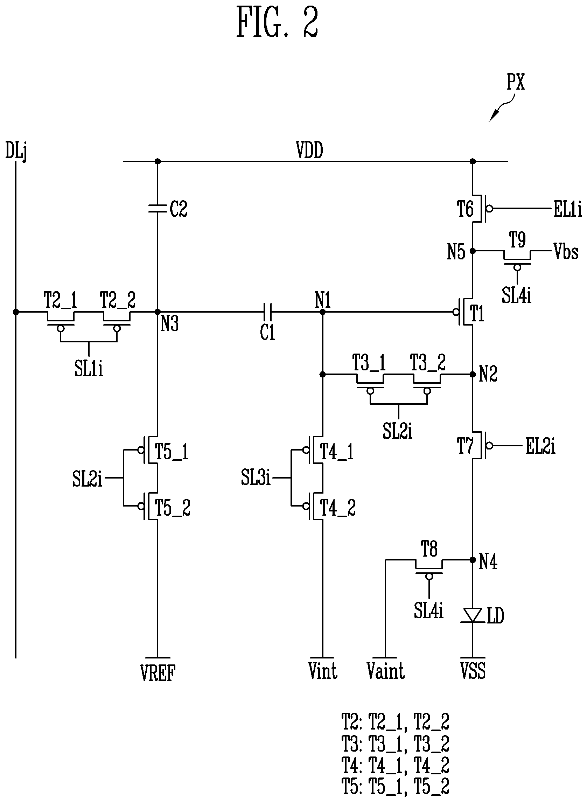

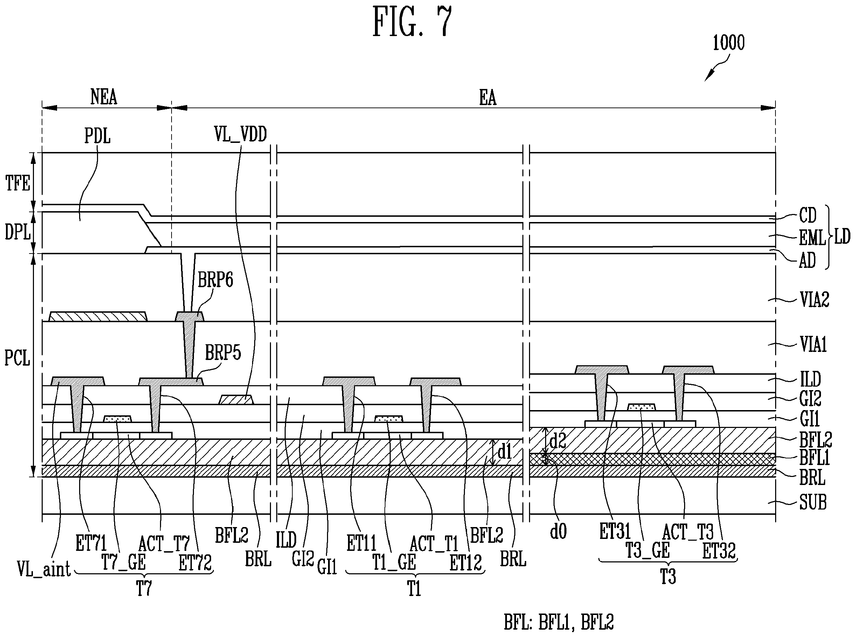

On the other hand, when the image refresh rate of the display device 1000 is varied, it may be desirable to prevent a leakage current from occurring, particularly during a low frequency driving. According to some embodiments, the leakage current can be reduced by introducing hydrogen into a semiconductor pattern including polysilicon through plasma treatment. However, because the driving voltage range (DR range) is also narrowed, a flicker phenomenon may be recognized. Hereinafter, the display device 1000 driven with a variable frequency according to some embodiments will be described with reference to FIGS. 1 to 6F, and the structure in which a concentration of hydrogen flowing into a semiconductor pattern is differentially applied by varying a stack structure of buffer layers (see BFL of FIGS. 7, 9, and 12) located under a driving transistor (e.g., see T1 of FIG. 2), where driving voltage range characteristics are important, and a switching transistor (e.g., see T3 of FIG. 2), where leakage current characteristics are important, in order for a low-frequency implementation of the display device 1000 including low-temperature polycrystalline silicon (LTPS) will be described with reference to FIGS. 7 to 14.

The display panel 100 may include pixels PX connected to data lines DL, scan lines SL1, SL2, SL3, and SL4, and emission control lines EL1 and EL2. The pixels PX may receive voltages of the first power supply VDD, the second power supply VSS, the initialization power supply Vint, and the reference power supply VREF from the outside. According to some embodiments, the pixel PX located in an i-th row and a j-th column (where i and j are natural numbers) may be connected to scan lines SL1i, SL2i, SL3i, and SL4i corresponding to an i-th pixel row, emission control lines EL1i and EL2i corresponding to the i-th pixel row, and a data line DLj corresponding to a j-th pixel column.

According to some embodiments of the present invention, the signal lines SL1, SL2, SL3, SL4, EL1, EL2, and DL connected to the pixel PX may be variously set to correspond to the circuit structure of the pixel PX.

The timing controller 900 may generate a first driving control signal SCS1, a second driving control signal SCS2, a third driving control signal SCS3, a fourth driving control signal SCS4, a fifth driving control signal ECS1, a sixth driving control signal ECS2, and a seventh driving control signal DCS according to synchronization signals supplied from the outside. The first driving control signal SCS1 may be supplied to the first scan driver 200, the second driving control signal SCS2 may be supplied to the second scan driver 300, the third driving control signal SCS3 may be supplied to the third scan driver 400, the fourth driving control signal SCS4 may be supplied to the fourth scan driver 500, the fifth driving control signal ECS1 may be supplied to the first emission driver 600, the sixth driving control signal ECS2 may be supplied to the second emission driver 700, and the seventh driving control signal DCS may be supplied to the data driver 800. In addition, the timing controller 900 may realign input image data supplied from the outside into image data RGB and supply the image data RGB to the data driver 800.

The first driving control signal SCS1 may include a first scan start pulse and clock signals. The first scan start pulse may control the first timing of the scan signal output from the first scan driver 200. The clock signals may be used to shift the first scan start pulse.

The second driving control signal SCS2 may include a second scan start pulse and clock signals. The second scan start pulse may control the first timing of the scan signal output from the second scan driver 300. The clock signals may be used to shift the second scan start pulse.

The third driving control signal SCS3 may include a third scan start pulse and clock signals. The third scan start pulse may control the first timing of the scan signal output from the third scan driver 400. The clock signals may be used to shift the third scan start pulse.

The fourth driving control signal SCS4 may include a fourth scan start pulse and clock signals. The fourth scan start pulse may control the first timing of the scan signal output from the fourth scan driver 500. The clock signals may be used to shift the fourth scan start pulse.

The fifth driving control signal ECS1 may include a first emission control start pulse and clock signals. The first emission control start pulse may control the first timing of the emission control signal output from the first emission driver 600. The clock signals may be used to shift the first emission control start pulse.

The sixth driving control signal ECS2 may include a second emission control start pulse and clock signals. The second emission control start pulse may control the first timing of the emission control signal output from the second emission driver 700. The clock signals may be used to shift the second emission control start pulse.

The seventh driving control signal DCS may include a source start pulse and clock signals. The source start pulse may control a sampling start time of data. The clock signals may be used to control a sampling operation.

The first scan driver 200 may receive the first driving control signal SCS1 from the timing controller 900, and may supply a scan signal (e.g., a first scan signal) to the first scan lines SL1 based on the first driving control signal SCS1. For example, the first scan driver 200 may sequentially supply the first scan signal to the first scan lines SL1. When the first scan signal is sequentially supplied, the pixels PX may be selected in units of horizontal lines (or units of pixel rows) and the data signal may be supplied to the pixels PX. That is, the first scan signal may be a signal used to write data.

The first scan signal may be set to a gate-on level (e.g., a low voltage). The transistor that is included in the pixel PX and receives the first scan signal may be set to a turned-on state when the first scan signal is supplied.

According to some embodiments, in response to one of the first scan lines SL1 (e.g., the first scan line SL1i), the first scan driver 200 may supply the scan signal (e.g., the first scan signal) to the first scan line SL1i at the same frequency (e.g., the second frequency) as the image refresh rate of the display device 1000. The second frequency may be set as a divisor of the first frequency for driving the emission drivers 600 and 700.

The first scan driver 200 may supply the scan signal to the first scan lines SL1 during the display scan period of one frame. For example, the first scan driver 200 may supply at least one scan signal to each of the first scan lines SL1 during the display scan period.

The second scan driver 300 may receive the second driving control signal SCS2 from the timing controller 900, and may supply a scan signal (e.g., a second scan signal) to the second scan lines SL2 based on the second driving control signal SCS2. For example, the second scan driver 300 may sequentially supply the second scan signal to the second scan lines SL2. The second scan signal may be supplied to initialize transistors and capacitors included in the pixels PX and/or compensate a threshold voltage (Vth). When the second scan signal is supplied, the pixels PX may perform threshold voltage compensation and/or initialization operations. The second scan signal may be set to a gate-on level (e.g., a low voltage). The transistor that is included in the pixel PX and receives the second scan signal may be set to a turned-on state when the second scan signal is supplied.

According to some embodiments, in response to one of the second scan lines SL2 (e.g., the second scan line SL2i), the second scan driver 300 may supply the scan signal (e.g., the second scan signal) to the second scan line SL2i at the same frequency (e.g., a second frequency) as the output of the first scan driver 200.

The second scan driver 300 may supply the scan signal to the second scan lines SL2 during the display scan period of one frame. For example, the second scan driver 300 may supply at least one scan signal to each of the second scan lines SL2 during the display scan period.

The third scan driver 400 may receive the third driving control signal SCS3 from the timing controller 900, and may supply a scan signal (e.g., a third scan signal) to the third scan lines SL3 based on the third driving control signal SCS3. For example, the third scan driver 400 may sequentially supply the third scan signal to the third scan lines SL3. The third scan signal may be supplied to initialize the driving transistors included in the pixels PX and/or initialize the capacitors included in the pixels PX. When the third scan signal is supplied, the pixels PX may perform an operation of initializing the driving transistors and/or the capacitors.

The third scan signal may be set to a gate-on level (e.g., a low voltage). The transistor that is included in the pixel PX and receives the third scan signal may be set to a turned-on state when the third scan signal is supplied.

According to some embodiments, in response to one of the third scan lines SL3 (e.g., the third scan line SL3i), the third scan driver 400 may supply the scan signal (e.g., the third scan signal) to the third scan line SL3i at the same frequency (e.g., a second frequency) as the output of the first scan driver 200.

The fourth scan driver 500 may receive the fourth driving control signal SCS4 from the timing controller 900, and may supply a scan signal (e.g., a fourth scan signal) to the fourth scan lines SL4 based on the fourth driving control signal SCS4. For example, the fourth scan driver 500 may sequentially supply the fourth scan signal to the fourth scan lines SL4. The fourth scan signal may be supplied to initialize the light emitting element included in the pixels PX and to supply a bias voltage (e.g., a set or predetermined bias voltage) (e.g., an on-bias voltage) to the source electrode of the driving transistor included in the pixels PX. When the fourth scan signal is supplied, the pixels PX may perform an operation of initializing the light emitting element and supplying the bias voltage.

The fourth scan signal may be set to a gate-on level (e.g., a low voltage). The transistor that is included in the pixel PX and receives the fourth scan signal may be set to a turned-on state when the fourth scan signal is supplied.

According to some embodiments, in response to one of the fourth scan lines SL4 (e.g., the fourth scan line SL4i), the fourth scan driver 500 may supply the scan signal (e.g., the fourth scan signal) to the fourth scan line SL4i at the first frequency. Therefore, the scan signal respectively supplied to the fourth scan lines SL4 may be repeatedly supplied at each period (e.g., set or predetermined period) within one frame period.

Therefore, when the image refresh rate is reduced, the number of repetitions of the operation of supplying the fourth scan signal within one frame period may be increased.

The first emission driver 600 may receive the fifth driving control signal ECS1 from the timing controller 900, and may transmit the emission control signal (e.g., the first emission control signal) to the first emission control lines EL1 based on the fifth driving control signal ECS1. For example, the first emission driver 600 may sequentially supply the first emission control signal to the first emission control lines EL1.

The second emission driver 700 may receive the sixth driving control signal ECS2 from the timing controller 900, and may supply the emission control signal (e.g., the second emission control signal) to the second emission control lines EL2 based on the sixth driving control signal ECS2. For example, the second emission driver 700 may sequentially supply the second emission control signal to the second emission control lines EL2.

When the first emission control signal and/or the second emission control signal are supplied, the pixels PX may not emit light in units of horizontal lines (or units of pixel rows). To this end, the first emission control signal and the second emission control signal may be set to a gate-off level (e.g., a high voltage) so that the transistors included in the pixels PX are turned off. The transistor that is included in the pixel PX and receives the first emission control signal and/or the second emission control signal may be turned off when the first emission control signal and/or the second emission control signal is supplied, and may be set to a turned-on state in the other cases.

The first emission control signal and the second emission control signal may be used to control the emission time of the pixels PX. To this end, the first emission control signal and the second emission control signal may be set to have a relatively wider width than the scan signal.

According to some embodiments, the first emission control signal and/or the second emission control signal may have a plurality of gate-off level (e.g., high voltage) periods during one frame period. For example, the first emission control signal and/or the second emission control signal may include a plurality of gate-on periods and a plurality of gate-off periods for initialization and threshold voltage compensation.

According to some embodiments, like the fourth scan driver 500, in response to one of the first emission control lines EL1 (e.g., the first emission control line EL1i) and one of the second emission control lines EL2 (e.g., the emission control line EL2i), the first and second emission drivers 600 and 700 may supply the emission control signals (e.g., the first and second emission control signals) to the first and second emission control lines EL1i and EL2i at the first frequency. Therefore, the emission control signals respectively supplied to the first and second emission control lines EL1 and EL2 may be repeatedly supplied at each period (e.g., each set or predetermined period) within one frame period.

The data driver 800 may receive the seventh driving control signal DCS and the image data RGB from the timing controller 900. The data driver 800 may supply the data signal to the data lines DL in response to the seventh driving control signal DCS. The data signal supplied to the data lines DL may be supplied to the pixels PX selected by the scan signal (e.g., the first scan signal). To this end, the data driver 800 may supply the data signal to the data lines DL so as to be synchronized with the scan signal.

According to some embodiments, the data driver 800 may supply the data signal to the data lines DL during one frame period in response to the image refresh rate. For example, the data driver 800 may supply the data signal so as to be synchronized with the scan signal supplied to the first scan lines SL1.

FIG. 2 is a circuit diagram illustrating a pixel according to embodiments of the present invention. For convenience of description, FIG. 2 illustrates the pixel PX positioned on the i-th horizontal line (or the i-th pixel row) and connected to the j-th data line DLj.

Referring to FIG. 2, the pixel PX may include a light emitting element LD, first to ninth transistors T1 to T9, a first capacitor C1, and a second capacitor C2.

A first electrode (or an anode) of the light emitting element LD may be connected to a second electrode (e.g., a drain electrode) of the first transistor T1 (or a second node N2) via the seventh transistor T7, and a second electrode (or a cathode) of the light emitting element LD may be connected to a second power supply VSS.

The first transistor T1 may be connected to a first power supply VDD via the sixth transistor T6, and may be connected to the first electrode of the light emitting element LD via the seventh transistor T7. The first transistor T1 may generate a driving current and provide the driving current to the light emitting element LD. A gate electrode of the first transistor T1 may be connected to a first node N1. The first transistor T1 may function as a driving transistor of the pixel PX. The first transistor T1 may control the amount of a current flowing from the first power supply VDD to the second power supply VSS via the light emitting element LD in response to a voltage applied to the first node N1.

The first capacitor C1 may be connected between the first node N1 corresponding to the gate electrode of the first transistor T1 and the second electrode of the second transistor T2 (or a third node N3). The first capacitor C1 may store a voltage corresponding to a voltage difference between the first node N1 and the third node N3.

The second capacitor C2 may be connected between the first power supply VDD and the third node N3. The second capacitor C2 may store a voltage corresponding to a voltage difference between the first power supply VDD and the third node N3. One electrode of the second capacitor C2 is connected to the first power supply VDD that is a constant voltage source, and the other electrode of the second capacitor C2 is connected to the third node N3. Therefore, the second capacitor C2 may maintain the data signal (or data voltage), which is written to the third node N3 through the second transistor T2 in the display scan period, during the self-scan period in which the data signal is not written. That is, the second capacitor C2 may stabilize the voltage of the third node N3.

The second transistor T2 may be connected between the data line DLj and the third node N3. The second transistor T2 according to some embodiments may include a (2_1)th transistor T2_1 and a (2_2)th transistor T2_2 connected in series. The second transistor T2 may include a gate electrode that receives the scan signal. For example, the gate electrode of the second transistor T2 may be connected to the first scan line SL1i to receive the first scan signal. The second transistor T2 may be turned on when the first scan signal is supplied to the first scan line SL1i, and may electrically connect the data line DLj to the third node N3. Therefore, the data signal (or data voltage) may be transmitted to the third node N3.

The third transistor T3 may be connected between the first node N1 corresponding to the gate electrode of the first transistor T1 and the second electrode of the first transistor T1 (or the second node N2). The third transistor T3 according to some embodiments may include a (3_1)th transistor T3_1 and a (3_2)th transistor T3_2 connected in series. The third transistor T3 may include a gate electrode that receives the scan signal. For example, the gate electrode of the third transistor T3 may be connected to the second scan line SL2i to receive the second scan signal. The third transistor T3 may be turned on when the second scan signal is supplied to the second scan line SL2i, and may electrically connect the first node N1 to the second node N2. When the third transistor T3 is turned on, the first transistor T1 may be diode-connected. When the first transistor T1 is diode-connected, the threshold voltage of the first transistor T1 may be compensated for.

The fourth transistor T4 may be connected between the initialization power supply Vint and the first node N1. The fourth transistor T4 according to some embodiments may include a (4_1)th transistor T4_1 and a (4_2)th transistor T4_2 connected in series. The fourth transistor T4 may include a gate electrode that receives the scan signal. For example, the gate electrode of the fourth transistor T4 may be connected to the third scan line SL3i to receive the third scan signal. The fourth transistor T4 may be turned on when the third scan signal is supplied to the third scan line SL3i, and may electrically connect the initialization power supply Vint to the first node N1. Therefore, the voltage of the initialization power supply Vint may be supplied to the first node N1. Therefore, the voltage of the first node N1 may be initialized to the voltage of the initialization power supply Vint.

The fifth transistor T5 may be connected between the reference power supply VREF and the third node N3. The fifth transistor T5 according to some embodiments may include a (5_1)th transistor T5_1 and a (5_2)th transistor T5_2 connected in series. The fifth transistor T5 may include a gate electrode that receives the scan signal. For example, the gate electrode of the fifth transistor T5 may be connected to the second scan line SL2i to receive the second scan signal. The fifth transistor T5 may be turned on when the second scan signal is supplied to the second scan line SL2i, and may electrically connect the reference power supply VREF to the third node N3. Thus, the voltage of the reference power supply VREF may be supplied to the third node N3. Therefore, the voltage of the third node N3 may be initialized to the voltage of the reference power supply VREF.

On the other hand, because the gate electrodes of the third and fifth transistors T3 and T5 are connected to the same scan line (i.e., the second scan line SL2i), the third and fifth transistors T3 and T5 may be turned off or on at the same time.

The sixth transistor T6 may be connected between the first power supply VDD and the first electrode of the first transistor T1 (or the fifth node N5). The sixth transistor T6 may include a gate electrode that receives the emission control signal. For example, the gate electrode of the sixth transistor T6 may be connected to the first emission control line EL1i to receive the first emission control signal. The sixth transistor T6 may be turned off when the first emission control signal is supplied to the first emission control line EL1i, and may be turned on in the other cases. The sixth transistor T6 in the turned-on state may connect the first electrode of the first transistor T1 to the first power supply VDD.

The seventh transistor T7 may be connected between the second node N2 corresponding to the second electrode of the first transistor T1 and the anode of the light emitting element LD (or the fourth node N4). The seventh transistor T7 may include a gate electrode that receives the emission control signal. For example, the gate electrode of the seventh transistor T7 may be connected to the second emission control line EL2i to receive the second emission control signal. The seventh transistor T7 may be turned off when the second emission control signal is supplied to the second emission control line EL2i, and may be turned on in the other cases. The seventh transistor T7 in the turned-on state may electrically connect the second node N2 to the fourth node N4.

When both the sixth transistor T6 and the seventh transistor T7 are turned on, the light emitting element LD may emit light with a luminance corresponding to the voltage of the first node N1.

According to some embodiments, when the sixth transistor T6 is turned on and the seventh transistor T7 is turned off, the threshold voltage compensation of the first transistor T1 may be performed.

The eighth transistor T8 may be connected between the first electrode of the light emitting element LD (or the fourth node N4) and the anode initialization power supply Vaint. The eighth transistor T8 may include a gate electrode that receives the scan signal. For example, the gate electrode of the eighth transistor T8 may be connected to the fourth scan line SL4i to receive the fourth scan signal. The eighth transistor T8 may be turned on when the fourth scan signal is supplied to the fourth scan line SL4i, and may electrically connect the anode initialization power supply Vaint to the fourth node N4. Therefore, the voltage of the fourth node N4 (or the anode of the light emitting element LD) may be initialized to the voltage of the anode initialization power supply Vaint. When the voltage of the anode initialization power supply Vaint is supplied to the anode of the light emitting element LD, a parasitic capacitor of the light emitting element LD may be discharged. As the residual voltage charged in the parasitic capacitor is discharged (removed), unintentional fine light emission can be prevented. Therefore, the black expression capability of the pixel PX may be improved. On the other hand, because the operation of initializing the gate electrode of the first transistor T1 (or the first node N1) and the operation of initializing the anode of the light emitting element LD (or the fourth node N4) are separated, it is possible to prevent the light emitting element LD from unintentionally emitting light during the operation of initializing the gate electrode of the first transistor T1 (or the first node N1).

The ninth transistor T9 may be connected between the first electrode of the first transistor T1 (or the fifth node N5) and the bias power supply Vbs. The ninth transistor T9 may include a gate electrode that receives the scan signal. For example, the gate electrode of the ninth transistor T9 may be connected to the fourth scan line SL4i to receive the fourth scan signal. The ninth transistor T9 may be turned on when the fourth scan signal is supplied to the fourth scan line SL4i, and may electrically connect the fifth node N5 to the bias power supply Vbs. By using the ninth transistor T9, a bias may be periodically applied to the source electrode of the driving transistor (e.g., the first transistor T1) with a constant voltage. Therefore, a hysteresis deviation due to a difference in grayscale between adjacent pixels is eliminated, and thus screen drag may be reduced (removed).

On the other hand, FIG. 2 illustrates that the fourth transistor T4, the fifth transistor T5, and the eighth transistor T8 are P-type, but the present invention is not limited thereto. The third transistor T3, the fifth transistor T5, and the eighth transistor T8 may be formed as N-type.

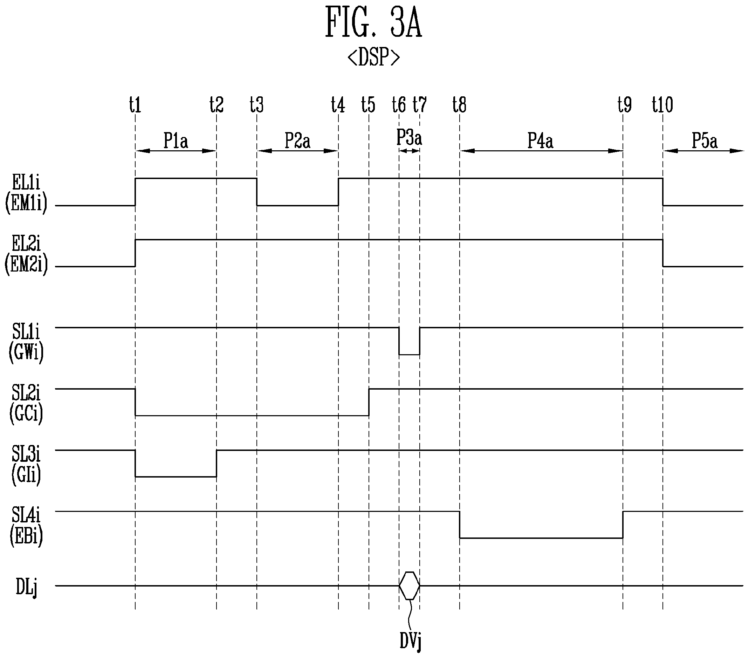

FIGS. 3A to 3F are waveform diagrams for describing the operation of the pixel of FIG. 2 during a display scan period according to some embodiments.

Referring to FIGS. 2 and 3A, the pixel PX may receive signals for image display during a display scan period DSP. The display scan period DSP may include a period in which the data signal DVj actually corresponding to an output image is written.

The first and second emission control signals EM1i and EM2i may be respectively supplied to the first and second emission control lines EL1i and EL2i, and the first to fourth scan signals GWi, GCi, GIi, and EBi may be respectively supplied to the first to fourth scan lines SL1i, SL2i, SL3i, and SL4i.

At the first time t1, the third scan signal GIi may transition from a gate-off level to a gate-on level. Thus, the fourth transistor T4 may be turned on. Therefore, the voltage of the initialization power supply Vint may be supplied to the first node N1 (or the gate electrode of the first transistor T1), and the first node N1 may be initialized to the voltage of the initialization power supply Vint.

In addition, the second scan signal GCi may transition from a gate-off level to a gate-on level. Therefore, the third transistor T3 may be turned on. However, because the second emission control signal EM2i maintains the gate-off level, the seventh transistor T7 maintains the turned-off state or the turned-off state. Thus, the voltage of the initialization power supply Vint supplied to the first node N1 is prevented from being supplied to the fourth node N4, thereby preventing the light emitting element LD from unintentionally emitting light.

In addition, the fifth transistor T5 may be turned on by the second scan signal GCi of the gate-on level. Therefore, the voltage of the reference power supply VREF may be supplied to the third node N3, and the third node N3 may be initialized to the voltage of the reference power supply VREF.

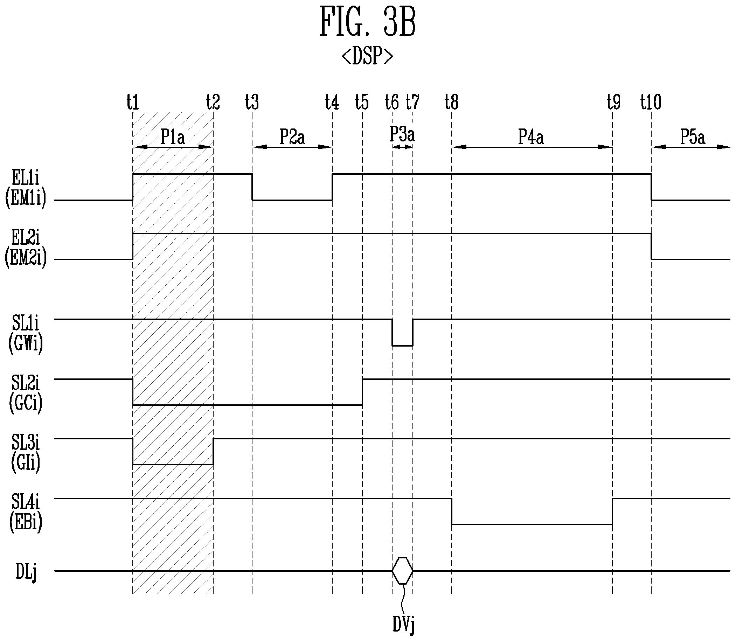

Accordingly, the voltage of the initialization power supply Vint may be supplied to the first node N1 during the first period P1a from the first time t1 to the second time t2 illustrated in FIG. 3B, and the voltage of the reference power supply VREF may be supplied to the third node N3. That is, the first period P1a may be an initialization period (or a first initialization period) for initializing the gate electrode of the first transistor T1 (or the first node N1) and the third node N3.

At the third time t3, the first emission control signal EM1i may transition from a gate-off level to a gate-on level. Therefore, the sixth transistor T6 may be turned on, and the first electrode (e.g., the source electrode) of the first transistor T1 may be connected to the first power supply VDD.

In addition, because the second scan signal GCi maintains the gate-on level, the third transistor T3 may maintain the turned-on state. Accordingly, the first transistor T1 may be diode-connected. In this case, a voltage corresponding to a difference (or voltage difference) between the voltage of the first power supply VDD and the threshold voltage of the first transistor T1 may be sampled at the first node N1.

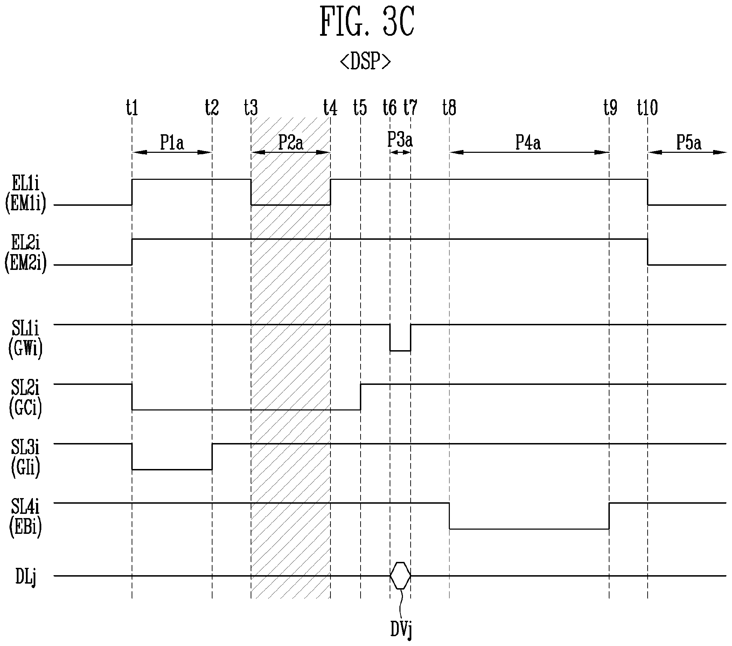

Therefore, because the first transistor T1 is diode-connected during the second period P2a from the third time t3 to the fourth time t4 illustrated in FIG. 3C, the threshold voltage of the first transistor T1 may be compensated for. That is, the second period P2a may be a threshold voltage compensation period.

On the other hand, in the second period P2a, the threshold voltage compensation may be performed by the voltage of the first power supply VDD, which is a constant voltage source. Therefore, the threshold voltage compensation operation may be performed based on a fixed voltage rather than a data signal (data voltage) that may vary according to pixel rows and/or frames.

At the fourth time t4, the first emission control signal EM1i may transition from a gate-on level to a gate-off level. Therefore, the sixth transistor T6 may be turned off.

At the fifth time t5, the second scan signal GCi may transition from a gate-on level to a gate-off level. Therefore, the third and fifth transistors T3 and T5 may be turned off.

At the sixth time t6, the first scan signal GWi may transition from a gate-off level to a gate-on level, and the second transistor T2 may be turned on. Therefore, the data signal DVj may be supplied to the third node N3.

Because the first node N1 is connected to the third node N3 by the first capacitor C1, the amount of change in the voltage of the third node N3 (i.e., "DATA - VREF") at the first node N1 may be reflected. Therefore, the voltage of the first node N1 may change to "VDD - Vth + (DATA - VREF)". DATA may be the voltage corresponding to the data signal DVj, VREF may be the voltage of the reference power supply VREF, VDD may be the voltage of the first power supply VDD, and Vth may be the threshold voltage of the first transistor T1.

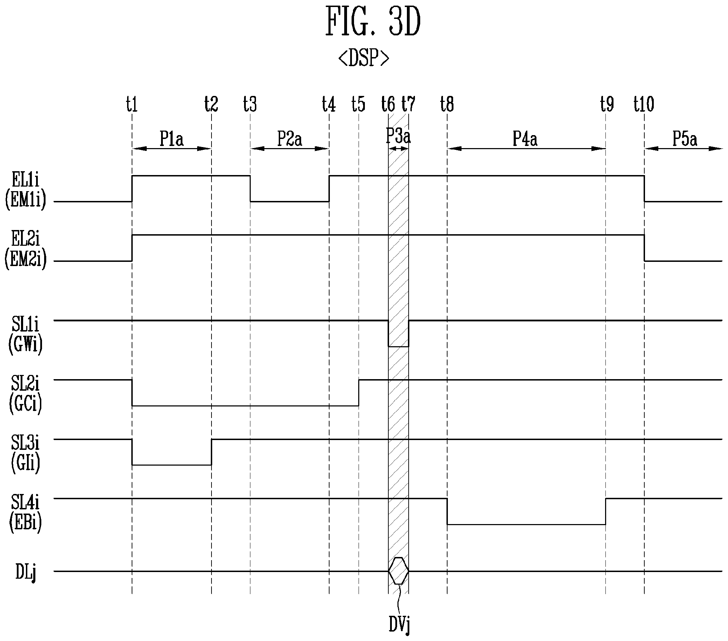

Therefore, the data signal DVj may be written to the pixel PX during the third period P3a from the sixth time t6 to the seventh time t7 illustrated in FIG. 3D. That is, the third period P3a may be a data write period.

According to some embodiments, the length of the third period P3a, that is, the length (pulse width) of the first scan signal GWi may be one horizontal period 1H. However, the length of the first scan signal GWi is not limited thereto. For example, the length of the first scan signal GWi may be two or more horizontal periods 2H.

At the seventh time point t7, the first scan signal GWi may transition from a gate-on level to a gate-off level. Therefore, the second transistor T2 may be turned off.

At the eighth time t8, the fourth scan signal EBi may transition from a gate-off level to a gate-on level. Therefore, the eighth transistor T8 may be turned on, and the voltage of the anode initialization power supply Vaint may be supplied to the fourth node N4. That is, the anode initialization of the light emitting element LD may be performed in the fourth period P4a.

In addition, the ninth transistor T9 is turned on, so that the voltage of the bias power supply Vbs may be supplied to the fifth node N5 (or the source electrode of the first transistor T1). Therefore, the voltage of the bias power supply Vbs having a positive voltage may be supplied to the first electrode (or the source electrode) of the first transistor T1.

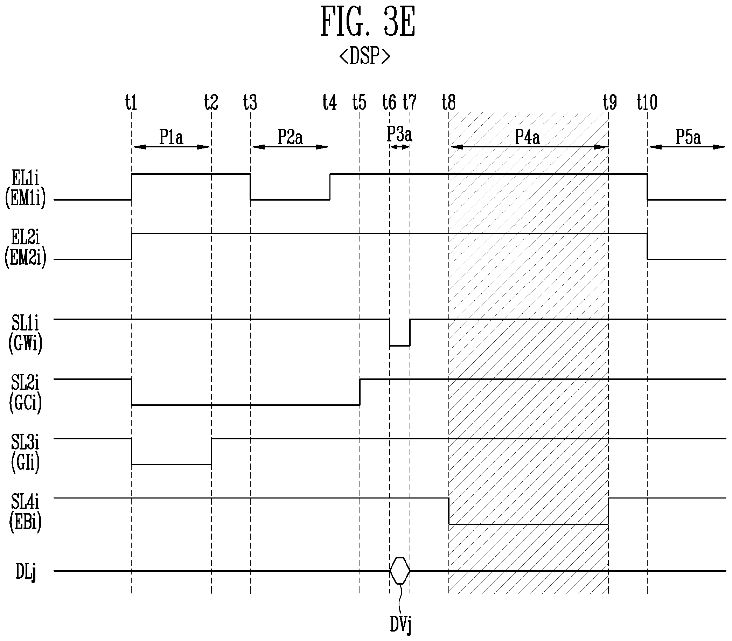

Accordingly, the on-bias may be applied to the first transistor T1 during the fourth period P4a from the eighth time t8 to the ninth time t9 illustrated in FIG. 3E. That is, the fourth period P4a may be an on-bias period (or a first on-bias period).

At the ninth time t9, the fourth scan signal EBi may transition from a gate-on level to a gate-off level. Therefore, the eighth transistor T8 and the ninth transistor T9 may be turned off.

By applying the on-bias to the first transistor T1 in the fourth period P4a, the hysteresis characteristics (i.e., the threshold voltage shift) of the first transistor T1 may be improved.

Therefore, the pixel PX and the display device 1000 in FIG. 1 according to the operations of FIGS. 3A to 3F remove or improve the hysteresis characteristics while removing the threshold voltage deviation of the first transistor T1, thereby improving image defects (flicker, color drag, deterioration in luminance, etc.). In particular, by applying the bias of a constant voltage to the source electrode of the first transistor T1 (or the driving transistor) to match the driving current direction and the bias direction, the hysteresis characteristics (difference in threshold voltage shift) may be improved more effectively.

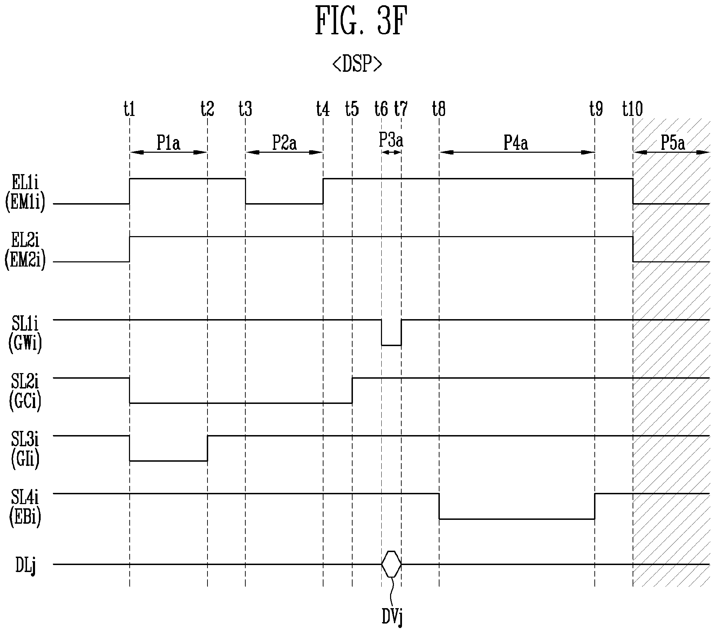

At the tenth time t10, the first and second emission control signals EM1i and EM2i may transition from a gate-off level to a gate-on level. Therefore, because the sixth and seventh transistors T6 and T7 may be turned on, the pixel PX may emit light in the fifth period P5a after the tenth time t10 illustrated in FIG. 3F. That is, the fifth period P5a may be an emission period (or a first emission period).

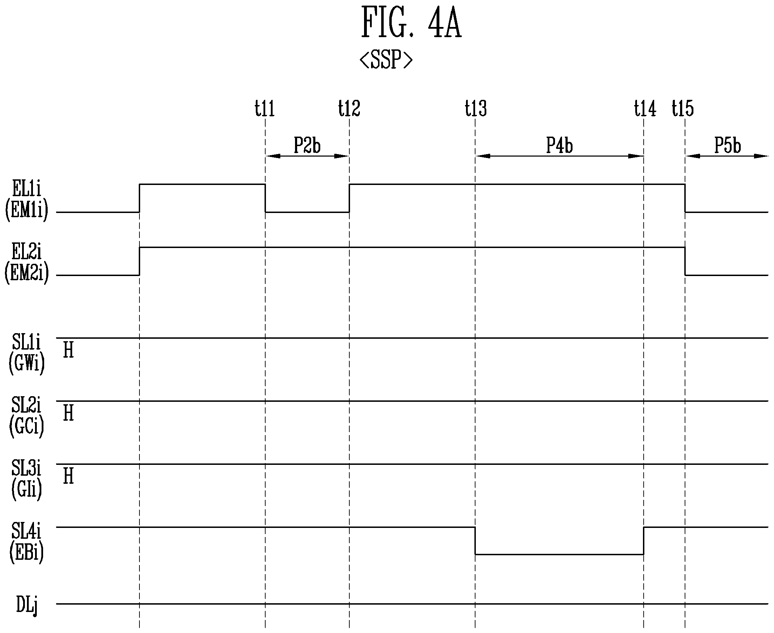

FIGS. 4A to 4D are waveform diagrams for describing the operation of the pixel of FIG. 2 during a self-scan period according to some embodiments.

Referring to FIGS. 2, 3A, and 4A, in order to maintain the luminance of an image output in the display scan period DSP, the on-bias voltage may be applied to the first electrode of the first transistor T1 (e.g., the source electrode or the fifth node N5).

According to the image frame rate, one frame may include at least one self-scan period SSP. The self-scan period SSP may includes an on-bias period (or a second on-bias period) of the sixth period P2b, an on-bias period (or a third on-bias period) of the seventh period P4b, and an emission period (or a second emission period) of the eighth period P5b.

According to some embodiments, the scan signals are not supplied to the second to fifth transistors T2, T3, T4, and T5 during the self-scan period SSP. For example, in the self-scan period SSP, the first scan signal GWi, the second scan signal GCi, and the third scan signal Gii respectively supplied to the first scan line SL1i, the second scan line SL2i, and the third scan line SL3i may have a gate-off level (or a high level (H)). Therefore, in the self-scan period SSP, the gate electrode initialization period (e.g., the first period P1a) of the first transistor T1, the threshold voltage compensation period (e.g., the second period P2a), and the data write period (e.g., the third period P3a) are not included.

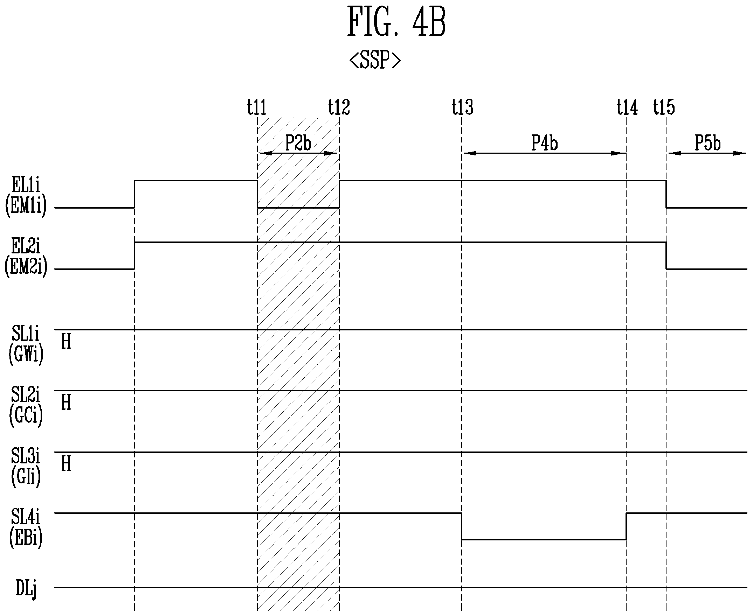

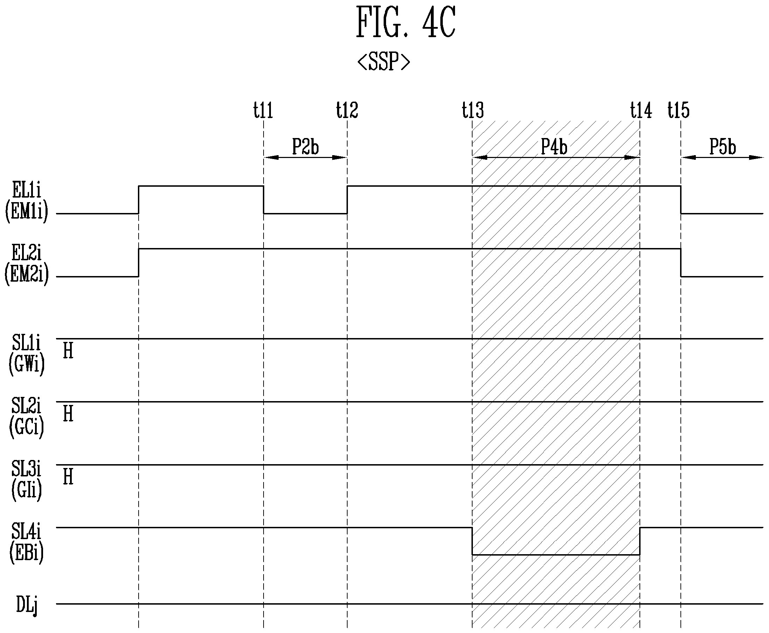

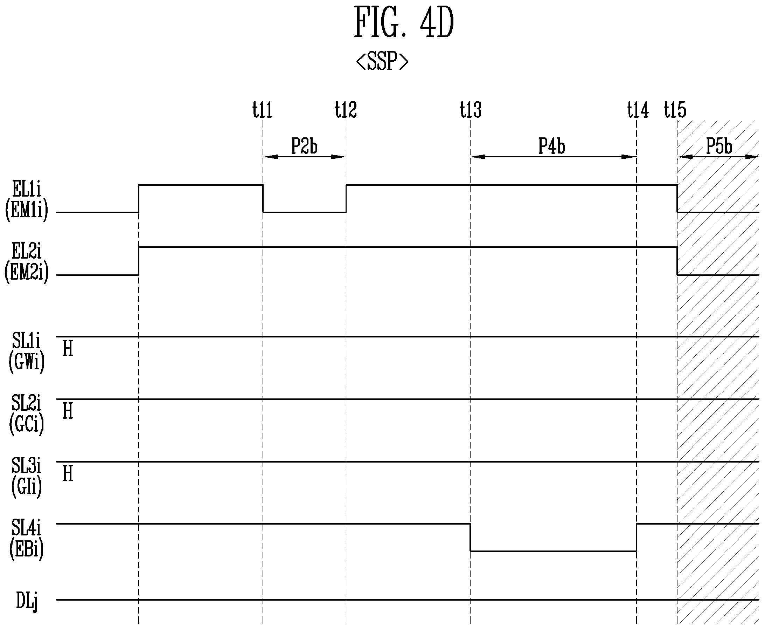

Because the first emission control signal EM1i of the gate-on level is supplied during the sixth period P2b (or the second on-bias period) from the eleventh time t11 to the twelfth time t12 illustrated in FIG. 4, the sixth transistor T6 may be turned on or maintain a turned-on state. Therefore, because the high voltage of the first power supply VDD is supplied to the first electrode (or the source electrode) of the first transistor T1, the first transistor T1 may have an on-bias state.

Because the fourth scan signal EBi of the gate-on level is supplied during the seventh period P4b (or the third on-bias period) from the thirteenth time t13 to the fourteenth time t14 illustrated in FIG. 4C, the ninth transistor T9 may be turned on or maintain a turned-on state. The ninth transistor T9 is turned on, so that the voltage of the bias power supply Vbs may be supplied to the fifth node N5 (or the source electrode of the first transistor T1). Therefore, the voltage of the bias power supply Vbs having a positive voltage may be supplied to the first electrode (or the source electrode) of the first transistor T1.

In addition, the eighth transistor T8 may be turned on. Therefore, the voltage of the anode initialization power supply Vaint is supplied to the fourth node N4 (or the first electrode of the light emitting element LD), and the fourth node N4 may be initialized to the voltage of the anode initialization power supply Vaint.

In the eighth period P5b (or the second emission period) after the fifteenth time t15 illustrated in FIG. 4D, both the first emission control signal EM1i and the second emission control signal EM2i have the gate-on level, and thus he sixth and seventh transistors T6 and T7 are turned on so that the pixel PX may emit light.

The fourth scan signal EBi and the first and second emission control signals EM1i and EM2i may be supplied at the first frequency regardless of the image refresh rate. Therefore, even when the image refresh rate changes, the initialization operation of the light emitting element LD and the on-bias application in the on-bias period (the fourth period P4a and/or the sixth period P2b and/or the seventh period P4b) are always periodically performed. Therefore, flicker may be improved in response to various image refresh rates (particularly, low-frequency driving).

On the other hand, in the self-scan period SSP, the data driver 800 of FIG. 1 may not supply the data signal to the pixel PX. Therefore, power consumption can be further reduced.

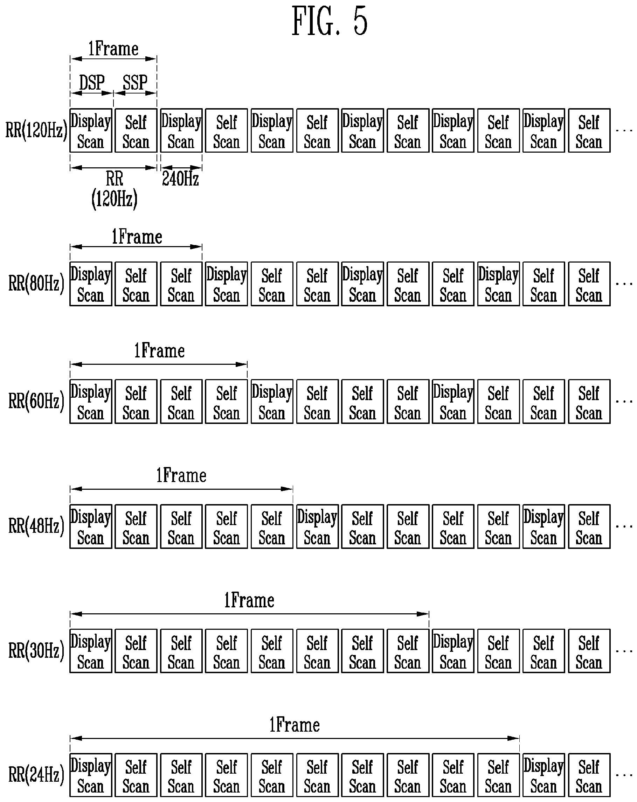

FIG. 5 is a conceptual diagram for describing an example of a method of driving a display device according to an image refresh rate.

Referring to FIGS. 1 to 5, the pixel PX may performs the operations of FIGS. 3A to 3G in the display scan period DSP and may perform the operations of FIGS. 4A to 4D in the self scan period SSP.

According to some embodiments, the output frequencies of the first scan signal GWi and the second scan signal GCi may vary according to the image refresh rate RR. For example, the first scan signal GWi and the second scan signal GCi may be output at the same frequency (second frequency) as the image refresh rate RR.

According to some embodiments, regardless of the image refresh rate RR, the third scan signal GIi, the fourth scan signal EBi, the first emission control signal EM1i, and the second emission control signal EM2i may be output at a constant frequency (first frequency). For example, the output frequencies of the third scan signal GIi, the fourth scan signal EBi, the first emission control signal EM1i, and the second emission control signal EM2i may be set to twice the maximum refresh rate of the display device 1000. According to some embodiments, the lengths of the display scan period DSP and the self scan period SSP may be substantially equal to each other. However, the number of self-scan periods SSP included in one frame period may be determined according to the image refresh rate RR.

As illustrated in FIG. 5, when the display device 1000 is driven at an image refresh rate RR of 120 Hz, one frame period may include one display scan period DSP and one self-scan period SSP. Therefore, when the display device 1000 is driven at an image refresh rate RR of 120 Hz, the pixels PX may alternately perform light emission and light non-emission and repeat twice during one frame period.

In addition, when the display device 1000 is driven at an image refresh rate RR of 80 Hz, one frame period may include one display scan period DSP and two successive self-scan periods SSP. Therefore, when the display device 1000 is driven at an image refresh rate RR of 80 Hz, the pixels PX may alternately perform light emission and light non-emission and repeat three times during one frame period.

In a manner similar to the above, the display device 1000 may be driven at a driving frequency of 60 Hz, 48 Hz, 30 Hz, 24 Hz, or 1 Hz by adjusting the number of self-scan periods SSP included in one frame period. In other words, the display device 1000 may support various image refresh rates RR at frequencies corresponding to a divisor of the first frequency.

In addition, as the driving frequency decreases, the number of self-scan periods SSP increases. Therefore, on-bias and/or off-bias of a magnitude (e.g., a set or predetermined magnitude) may be periodically applied to each of the first transistors T1 included in each of the pixels PX. Therefore, luminance reduction, flicker, and screen drag in low-frequency driving may be improved.

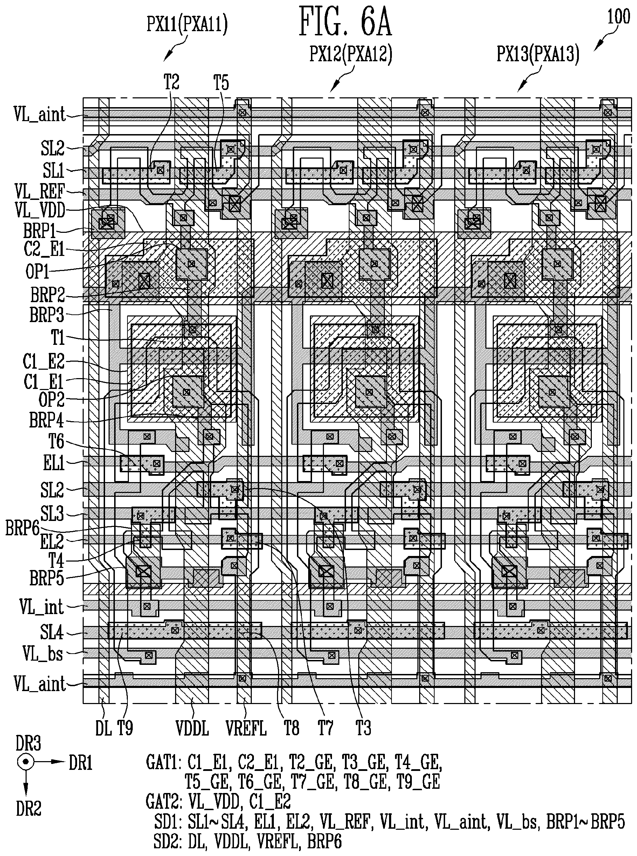

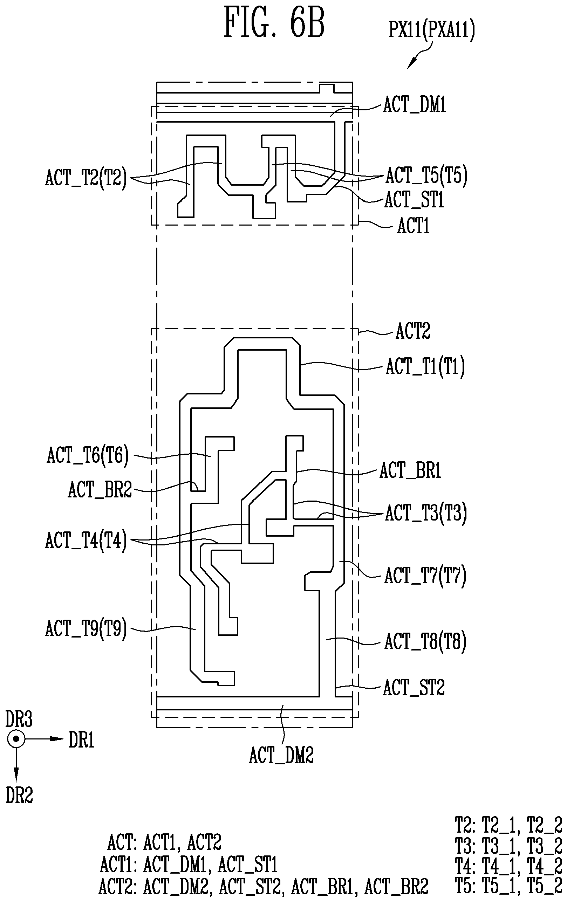

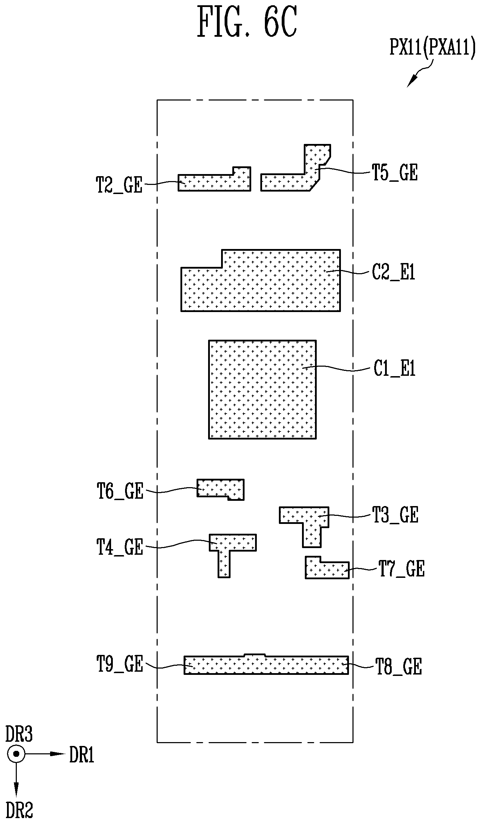

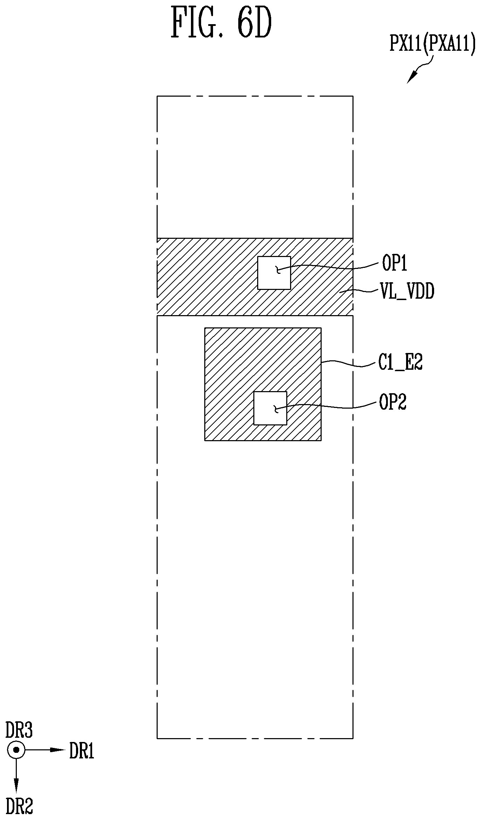

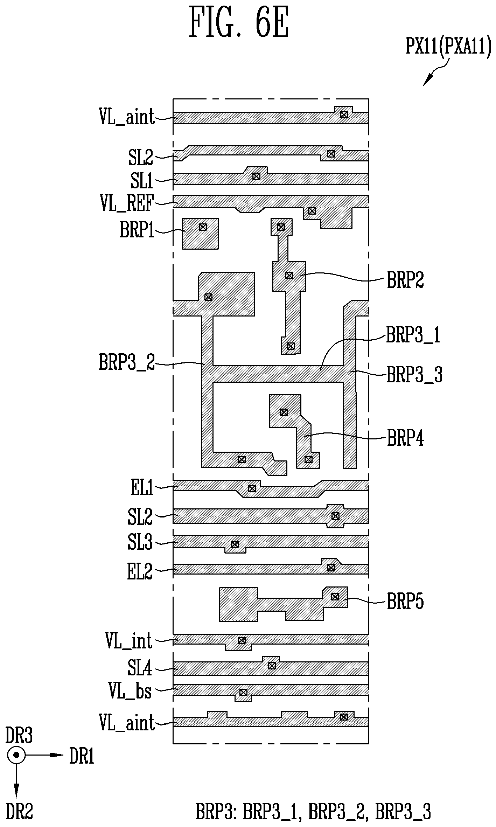

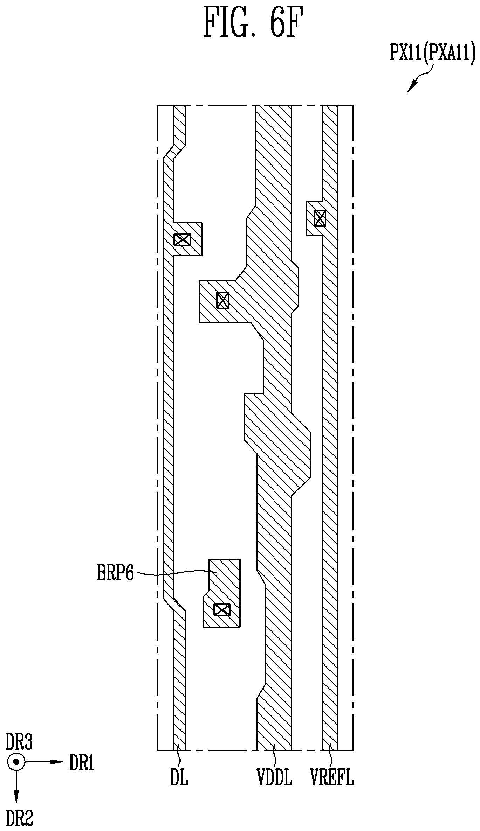

FIG. 6A is a schematic plan view of a plurality of pixels, when seen from above based on the pixel of FIG. 2. FIG. 6B is a plan view illustrating an example of a semiconductor layer included in the pixel of FIG. 6A. FIG. 6C is a plan view illustrating an example of a first conductive layer included in the pixel of FIG. 6A. FIG. 6D is a plan view illustrating an example of a second conductive layer included in the pixel of FIG. 6A. FIG. 6E is a plan view illustrating an example of a third conductive layer included in the pixel of FIG. 6A. FIG. 6F is a plan view illustrating an example of a fourth conductive layer included in the pixel of FIG. 6A.

Referring to FIGS. 1, 2, and 6A, the display panel 100 may include an eleventh pixel PX11 (or an eleventh pixel area PXA11), a twelfth pixel PX12 (or a twelfth pixel area PXA12), and a thirteenth pixel PX13 (or a thirteenth pixel area PXA13). The eleventh pixel PX11, the twelfth pixel PX12, and the thirteenth pixel PX13 may constitute one unit pixel.

According to some embodiments, the eleventh to thirteenth pixels PX11 to PX13 may emit light of different colors. For example, the eleventh pixel PX11 may be a red pixel emitting red light, the twelfth pixel PX12 may be a green pixel emitting green light, and the thirteenth pixel PX13 may be a blue pixel emitting blue light. However, the color, type, and/or number of pixels constituting the unit pixel are not particularly limited. For example, the color of light emitted by each pixel may be variously changed. According to some embodiments, the eleventh to thirteenth pixels PX11 to PX13 may emit light of the same color. For example, the eleventh to thirteenth pixels PX11 to PX13 may be blue pixels emitting blue light.

Because the eleventh to thirteenth pixels PX11 to PX13 (or the pixel driving circuits of the eleventh to thirteenth pixels PX11 to PX13) are substantially identical to or similar to each other, the eleventh pixel PX11 will be described in more detail below, and the same may be equally applied to the eleventh to thirteenth pixels PX11 to PX13.

The eleventh pixel PX11 may include a semiconductor layer ACT, a first conductive layer GAT1, a second conductive layer GAT2, a third conductive layer SD1, and a fourth conductive layer SD2. The semiconductor layer ACT, the first conductive layer GAT1, the second conductive layer GAT2, the third conductive layer SD1, and the fourth conductive layer SD2 may be formed on different layers through different processes.

The semiconductor layer ACT may be an active layer forming channels of the first to ninth transistors T1 to T9. The semiconductor layer ACT may include a source region (or a first region) and a drain region (or a second region) in contact with the first electrode (e.g., the source electrode) and the second electrode (e.g., the drain electrode) of each of the first to ninth transistors T1 to T9. A region between the source region and the drain region may be a channel region. The channel region of the semiconductor pattern is a semiconductor pattern that is not doped with impurities, and may be an intrinsic semiconductor. The source region and the drain region may be a semiconductor pattern doped with impurities.

Referring to FIGS. 6A and 6B, the semiconductor layer ACT may include a first semiconductor pattern group ACT1 and a second semiconductor pattern group ACT2.

The first semiconductor pattern group ACT1 may include a first dummy part ACT_DM1 and a first stem part ACT_ST1. The first dummy part ACT_DM1 and the first stem part ACT_ST1 may be interconnected and integrally formed.

The first dummy part ACT_DM1 may extend in the first direction DR1 and may be positioned adjacent to one side of the eleventh pixel area PXA11. Because the first dummy part ACT_DM1 continuously extends from the eleventh pixel area PXA11, the twelfth pixel area PXA12, and the thirteenth pixel area PXA13, the first semiconductor pattern group ACT1 may be interconnected in the first direction DR1 on the display panel 100.

The first stem part ACT_ST1 may include a second semiconductor pattern ACT_T2 and a fifth semiconductor pattern ACT_T5. The second semiconductor pattern ACT_T2 may constitute the channel of the second transistor T2, and the fifth semiconductor pattern ACT_T5 may constitute the channel of the fifth transistor T5. According to some embodiments, the second transistor T2 may include (2_1)th and (2_2)th transistors T2_1 and T2_2, and the second semiconductor pattern ACT_T2 may include channel regions of the (2_1)th and (2_2)th transistors T2_1 and T2_2, that is, two channel regions connected in series. Similarly, the fifth transistor T5 may include (5_1)th and (5_2)th transistors T5_1 and T5_2, and the fifth semiconductor pattern ACT_T5 may include channel regions of the (5_1)th and (5_2)th transistors T5_1 and T5_2, that is, two channel regions connected in series. Each of the second semiconductor pattern ACT_T2 and the fifth semiconductor pattern ACT_T5 may include a curved portion for forming a dual gate.

The second semiconductor pattern group ACT2 may include a second dummy part ACT_DM2 and a second stem part ACT_ST2. The second dummy part ACT_DM2 and the second stem part ACT_ST2 may be interconnected and integrally formed.

The second dummy part ACT_DM2 may extend in the first direction DR1 and may be positioned adjacent to the other side of the eleventh pixel area PXA11. Because the second dummy part ACT_DM2 continuously extends from the eleventh pixel area PXA11, the twelfth pixel area PXA12, and the thirteenth pixel area PXA13, the second semiconductor pattern group ACT2 may be interconnected in the first direction DR1 on the display panel 100.

The second stem part ACT_ST2 may include a first branch part ACT_BR1 and a second branch part ACT_BR2. The second stem part ACT_ST2 may include an eighth semiconductor pattern ACT_T8, a seventh semiconductor pattern ACT_T7, a first semiconductor pattern ACT_T1, and a ninth semiconductor pattern ACT_T9 in a counterclockwise direction. The eighth semiconductor pattern ACT_T8 may constitute the channel of the eighth transistor T8, the seventh semiconductor pattern ACT_T7 may constitute the channel of the seventh transistor T7, the first semiconductor pattern ACT_T1 may constitute the channel of the first transistor T1, and the ninth semiconductor pattern ACT_T9 may constitute the channel of the ninth transistor T9.

According to some embodiments, the first semiconductor pattern ACT_T1 may include a curved portion for improving a channel capacitance.

According to some embodiments, the first branch part ACT_BR1 may be branched between the first semiconductor pattern ACT_T1 and the seventh semiconductor pattern ACT_T7. The first branch part ACT_BR1 may include a third semiconductor pattern ACT_T3 and a fourth semiconductor pattern ACT_T4.

The third semiconductor pattern ACT_T3 may constitute the channel of the third transistor T3, and the fourth semiconductor pattern ACT_T4 may constitute the channel of the fourth transistor T4. According to some embodiments, the third transistor T3 may include (3_1)th and (3_2)th transistors T3_1 and T3_2, and the third semiconductor pattern ACT_T3 may include channel regions of the (3_1)th and (3_2)th transistors T3_1 and T3_2, that is, two channel regions connected in series. Similarly, the fourth transistor T4 may include (4_1)th and (4_2)th transistors T4_1 and T4_2, and the fourth semiconductor pattern ACT_T4 may include channel regions of the (4_1)th and (4_2)th transistors T4_1 and T4_2, that is, two channel regions connected in series. Each of the third semiconductor pattern ACT_T3 and the fourth semiconductor pattern ACT_T4 may include a curved portion for forming a dual gate.

The second branch part ACT_BR2 may be branched between the first semiconductor pattern ACT_T1 and the ninth semiconductor pattern ACT_T9. The second branch part ACT_BR2 may include a sixth semiconductor pattern ACT_T6. The sixth semiconductor pattern ACT_T6 may constitute the channel of the sixth transistor T6.

Referring to FIGS. 6A to 6C, for the first semiconductor pattern group and the second semiconductor pattern group, the first conductive layer GAT1 may include an eleventh capacitor electrode C1_E1, a twenty-first capacitor electrode C2_E1, and gate patterns T2_GE, T3_GE, T4_GE, T5_GE, T6_GE, T7_GE, T8_GE, and T9_GE of the second to ninth transistors T2 to T9.

The eleventh capacitor electrode C1_E1 may have a specific area, may be generally positioned in the center of the eleventh pixel area PXA11, and may overlap the first semiconductor pattern ACT_T1. The eleventh capacitor electrode C1_E1 may constitute the gate electrode of the first transistor T1.

The twenty-first capacitor electrode C2_E1 may have a specific area and may be positioned above the eleventh capacitor electrode C1_E1.

The gate pattern T2_GE of the second transistor T2 may extend in the first direction DR1, and may overlap the channel region formed in the bent portion of the second semiconductor pattern ACT_T2 to configure the gate electrodes of the (2_1)th and (2_2)th transistors T2_1 and T2_2.

The gate pattern T3_GE of the third transistor T3 may extend in the first direction DR1, may be branched in the second direction DR2, and may overlap the channel region formed in the bent portion of the third semiconductor pattern ACT_T3 to configure the gate electrodes of the (3_1)th and (3_2)th transistors T3_1 and T3_2.

The gate pattern T4_GE of the fourth transistor T4 may extend in the first direction DR1, may be branched in the second direction DR2, and may overlap the channel region formed in the bent portion of the fourth semiconductor pattern ACT_T4 to configure the gate electrodes of the (4_1)th and (4_2)th transistors T4_1 and T4_2.

The gate pattern T5_GE of the fifth transistor T5 may extend in the first direction DR1, and may overlap the channel region formed in the bent portion of the fifth semiconductor pattern ACT_T5 to configure the gate electrodes of the (5_1)th and (5_2)th transistors T5_1 and T5_2.

The gate pattern T6_GE of the sixth transistor T6 may extend in the first direction DR1, and may overlap the channel region formed in the sixth sub-semiconductor pattern ACT_T2 to configure the gate electrode of the sixth transistor T6.

The gate pattern T7_GE of the seventh transistor T7 may extend in the first direction DR1, and may overlap the channel region formed in the seventh semiconductor pattern ACT_T7 to configure the gate electrode of the seventh transistor T7.

The gate pattern T8_GE of the eighth transistor T8 and the gate pattern T9_GE of the ninth transistor T9 may be integrally formed and extend in the first direction DR1. The gate pattern T8_GE of the eighth transistor T8 may overlap the channel region formed in the eighth semiconductor pattern ACT_T8 to configure the gate electrode of the eighth transistors T8, and the gate pattern T9_GE of the ninth transistor T9 may overlap the channel region formed in the ninth semiconductor pattern ACT_T9 to configure the gate electrode of the ninth transistors T9.

The first conductive layer GAT1 may include at least one metal selected from molybdenum (Mo), aluminium (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu). The first conductive layer GAT1 may have a single-layer or multilayer structure. For example, the first conductive layer GAT1 may have a single-layer structure including molybdenum (Mo).

Referring to FIGS. 6A to 6D, the second conductive layer GAT2 may include a twelfth capacitor electrode C1_E2 and a (1_1)th power line VL_VDD.

The (1_1)th power line VL_VDD may extend in the first direction DR1, may overlap the twenty-first capacitor electrode C2_E1, and may configure the second capacitor (see C2 of FIG. 2) together with the twenty-first capacitor electrode C2_E1. The area of the (1_1)th power line VL_VDD may be larger than the area of the twenty-first capacitor electrode C2_E1 and may cover the twenty-first capacitor electrode C2_E1. On the other hand, the (1_1)th power line VL_VDD may include a first opening OP1 for connecting a second bridge pattern BRP2 including the third conductive layer SD1 to the twenty-first capacitor electrode C2_E1 including the first conductive layer GAT1.

The twelfth capacitor electrode C1_E2 may overlap the eleventh capacitor electrode C1_E1, and may configure the first capacitor (see C1 of FIG. 2) together with the eleventh capacitor electrode C1_E1. The area of the twelfth capacitor electrode C1_E2 may be larger than the area of the eleventh capacitor electrode C1_E1 and may cover the eleventh capacitor electrode C1_E1. On the other hand, the twelfth capacitor electrode C1_E2 may include a second opening OP2 for connecting a fourth bridge pattern BRP4 including the third conductive layer SD1 to the eleventh capacitor electrode C1_E1 including the first conductive layer GAT1.

The second conductive layer GAT2 may include at least one metal selected from molybdenum (Mo), aluminium (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu). The second conductive layer GAT2 may have a single-layer or multilayer structure. For example, the second conductive layer GAT2 may have a single-layer structure including molybdenum (Mo).

Referring to FIGS. 6A to 6E, the third conductive layer SD1 may include first to fourth scan lines SL1, SL2, SL3, and SL4, first and second emission control lines EL1 and EL2, a (3_1)th power line VL_REF, a fourth power line VL_int, a fifth power line VL_aint, a sixth power line VL_bs, and first to fifth bridge patterns BRP1 to BRP5.

The first scan line SL1 may extend in the first direction DR1. The first scan line SL1 may be connected to the gate pattern T2_GE of the second transistor T2 through a contact hole.

The second scan line SL2 may extend in the first direction DR1. The second scan line SL2 may be connected to the gate pattern T3_GE of the third transistor T3 through a contact hole, and may be connected to the gate pattern T5_GE of the fifth transistor T5 through a contact hole.

The third scan line SL3 may extend in the first direction DR1. The third scan line SL3 may be connected to the gate pattern T4_GE of the fourth transistor T4 through a contact hole.

The fourth scan line SL4 may extend in the first direction DR1. The fourth scan line SL4 may be connected to the gate patterns T8_GE and T9_GE of the eighth and ninth transistors T8 and T9 formed integrally through a contact hole.

The first emission control line EL1 may extend in the first direction DR1. The first emission control line EL1 may be connected to the gate pattern T6_GE of the sixth transistor T6 through a contact hole.

The second emission control line EL2 may extend in the first direction DR1. The second emission control line EL2 may be connected to the gate pattern T7_GE of the seventh transistor T7 through a contact hole.

The (3_1)th power line VL_REF may extend in the first direction DR1. The (3_1)th power line VL_REF may be connected to one electrode of the fifth transistor T5 through a contact hole.

The fourth power line VL_int may extend in the first direction DR1. The fourth power line VL_int may be connected to one electrode of the fourth transistor T4 through a contact hole.

The fifth power line VL_aint may extend in the first direction DR1. The fifth power line VL_aint may be connected to one electrode of the eighth transistor T8 through a contact hole.

The sixth power line VL_bs may extend in the first direction DR1. The sixth power line VL_bs may be connected to one electrode of the ninth transistor T9 through a contact hole.

The first bridge pattern BRP1 may overlap one electrode of the second transistor T2 and may be connected to one electrode of the second transistor T2 through a contact hole. In addition, the first bridge pattern BRP1 may be connected to the data line DL including the fourth conductive layer SD2 through a contact hole. That is, the first bridge pattern BRP1 may connect one electrode of the second transistor T2 to the data line DL.

The second bridge pattern BRP2 may extend in the second direction DR2 and may overlap a portion of the first semiconductor pattern group ACT1, the twelfth capacitor electrode C1_E2, and the twenty-first capacitor electrode C2_E1. The second bridge pattern BRP2 may be connected to a portion of the first semiconductor pattern group ACT1 through a contact hole, and may be connected to one electrode of the second transistor T2 and one electrode of the fifth transistor T5. In addition, the second bridge pattern BRP2 may be connected to the twelfth capacitor electrode C1_E2 through a contact hole. In addition, the second bridge pattern BRP2 may be connected to the twenty-first capacitor electrode C2_E1 exposed by the first opening OP1 formed in the (1_1)th power line VL_VDD. That is, the second bridge pattern BRP2 may configure the third node N3 of FIG. 2.

The third bridge pattern BRP3 may overlap one electrode of the (1_1)th power line VL_VDD and the sixth transistor T6. The third bridge pattern BRP3 may overlap one electrode of the (1_1)th power line VL_VDD and the sixth transistor T6 through a contact hole.

On the other hand, the third bridge pattern BRP3 may have an 'H' shape. In other words, the third bridge pattern BRP3 may include one horizontal part BRP3_1 extending in the first direction DR1, and a first vertical part BRP3_2 and a second vertical part BRP3_3 located at both ends of the horizontal part BRP3_1 and extending in the second direction DR2. In this case, the horizontal part BRP3_1 may be arranged to overlap the twelfth capacitor electrode C1_E2 in the third direction DR3. Each of the first and second vertical parts BRP3_2 and BRP3_3 may be spaced apart from the twelfth capacitor electrode C1_E2 by a distance (e.g., a set or predetermined distance) in a plan view.

The fourth bridge pattern BRP4 may connect one electrode of the first transistor T1 (or the eleventh capacitor electrode C1_E1) to one electrode of the third transistor T3. The fourth bridge pattern BRP4 may be connected to the eleventh capacitor electrode C1_E1 exposed by the second opening OP2 formed in the twelfth capacitor electrode C1_E2. In addition, the fourth bridge pattern BRP4 may be connected to one region of the third sub-semiconductor region ACT3_T3 through a contact hole.

The fifth bridge pattern BRP5 may connect one electrode of the seventh transistor T7 to the anode of the light emitting element LD.

Referring to FIGS. 6A to 6F, the fourth conductive layer SD2 may include a sixth bridge pattern BRP6, a data line DL, a first power line VDDL, and a third power line VREFL.

The sixth bridge pattern BRP6 may overlap the fifth bridge pattern BRP5 and may be connected to the fifth bridge pattern BRP5 through a contact hole. The sixth bridge pattern BRP6 may be connected to one electrode of the seventh transistor T7 through the fifth bridge pattern BRP5. In addition, the sixth bridge pattern BRP6 may be connected to the anode of the light emitting element LD through a contact hole. That is, the sixth bridge pattern BRP6 may connect one electrode of the seventh transistor T7 to the anode of the light emitting element LD together with the fifth bridge pattern BRP5.

The data line DL may extend in the second direction DR2, may be positioned on the left side of the eleventh pixel area PXA11 in the first direction DR1, and may overlap the first bridge pattern BRP1. The data line DL may be connected to the first bridge pattern BRP1 through a contact hole, and may be connected to one electrode of the second transistor T2 through the first bridge pattern BRP1.

The third power line VREFL may extend in the second direction DR2, may be positioned on the right side of the eleventh pixel area PXA11 in the first direction DR1, and may overlap the (3_1)th power line VL_REF. The third power line VREFL may be connected to the (3_1)th power line VL_REF through a contact hole, and may be connected to one electrode of the fifth transistor T2 through a contact hole.

The first power line VDDL may extend in the second direction DR2 and may be positioned between the data line DL and the third power line VREFL. The first power line VDDL may be connected to the third bridge pattern BRP3 (or the upper side of the first vertical part BRP3_2) through a contact hole.

As such, the first power line VDDL may extend in the second direction DR2, and the (1_1)th power line VL_VDD connected to the first power line VDDL through the third bridge pattern BRP3 and the contact hole may extend in the first direction DR1 to have a mesh structure. In addition, the third power line VREFL may extend in the second direction DR2, and the (3_1)th power line VL_REF connected to the third power line VREFL through the contact hole may extend in the first direction DR1 to have a mesh structure. As a result, IR drop may be reduced, and speckle dispersion of the display panel 100 may be reduced.

The third conductive layer SD1 and the fourth conductive layer SD2 may include at least one metal selected from molybdenum (Mo), aluminium (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu). The third conductive layer SD1 and the fourth conductive layer SD2 may have a single-layer or multilayer structure. For example, the third conductive layer SD1 and the fourth conductive layer SD2 may have a Ti/AL/Ti multilayer structure.

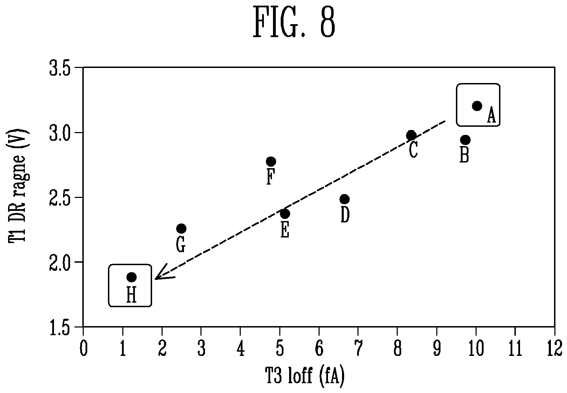

FIG. 7 is a partial cross-sectional view for describing the stack structure of the first transistor area, the third transistor area, and the seventh transistor area of FIG. 6A according to some embodiments. FIG. 8 is a graph showing a trade-off relationship between leakage current characteristics and a driving range.

Referring to FIGS. 2, 6A, and 7, because the eleventh to thirteenth pixels PX11 to PX13 are substantially identical to or similar to each other, the eleventh pixel PX11 will be described in more detail below, and the same may be equally applied to the eleventh to thirteenth pixels PX11 to PX13.

A general stack structure of the pixel PX through the seventh transistor T7 area electrically connected to the light emitting element LD will be described, and a structure and necessity in which the buffer layer BFL is differently formed for each area through the first transistor T1 area and the third transistor T3 area will be described.

A pixel circuit layer PCL, a display element layer DPL, and a thin film encapsulation layer TFE may be sequentially arranged on a base layer SUB (or substrate).

The pixel circuit layer PCL may include a barrier layer BRL, a buffer layer BFL, a semiconductor layer ACT, a first insulating layer GI1 (or a first gate insulating layer), a first conductive layer GAT1, a second insulating layer GI2 (or a second gate insulating layer), a second conductive layer GAT2, a third insulating layer ILD (or an interlayer insulating layer), a third conductive layer SD1, a first organic layer VIA1 (or a first via layer, a fourth insulating layer), a fourth conductive layer SD2, and a second organic layer VIA2 (or a second via layer, a fifth insulating layer).

The barrier layer BRL, the buffer layer BFL, the semiconductor layer ACT, the first insulating layer GI1, the first conductive layer GAT1, the second insulating layer GI2, the second conductive layer GAT2, the third insulating layer ILD, the third conductive layer SD1, the first organic layer VIA1, the fourth conductive layer SD2, and the second organic layer VIA2 may be sequentially stacked on the base layer SUB. Because the semiconductor layer ACT, the first conductive layer GAT1, the second conductive layer GAT2, the third conductive layer SD1, and the fourth conductive layer SD2 have been described with reference to FIG. 6A, redundant descriptions thereof will be omitted.

The base layer SUB may include an insulating material such as glass or resin. In addition, the base layer SUB may include a flexible material so as to be bendable or foldable, and may have a single-layer structure or a multilayer structure. For example, the flexible material may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, the material constituting the base layer SUB is not limited to the above-described embodiments.

The barrier layer BRL may be formed on the entire surface of the base layer SUB. The barrier layer BRL may block an unnecessary component such as moisture or oxygen from being introduced into the light emitting element from the outside. For example, the barrier layer BRL may include silicon oxide (SiOx). In addition, the thickness of the barrier layer BRL may be about 5,000 Å.

The buffer layer BFL may be formed on the entire surface of the barrier layer BRL. The buffer layer BFL may prevent diffusion of impurity ions and may prevent infiltration of moisture or external air. The buffer layer BFL may be an inorganic insulating layer including an inorganic material. For example, the buffer layer BFL may include a first buffer layer BFL1 including silicon nitride (SiNx) and a second buffer layer BFL2 including silicon oxide (SiOx). The buffer layer BFL may be provided as a single layer, or may be provided as a multilayer of at least a double layer. According to some embodiments, in response to the function of the transistor formed on the buffer layer BFL, only the second buffer layer BFL2 may be included in the transistor (e.g., the first transistor T1) area requiring good DR range characteristics, and both the first buffer layer BFL1 and the second buffer layer BFL2 may be included in the transistor (e.g., the third transistor T3) area requiring good leakage current characteristics. Hereinafter, this will be described in detail with reference to FIG. 8.

The semiconductor layer ACT may be located on the buffer layer BFL (or the second buffer layer BFL2). The semiconductor layer ACT may be located between the buffer layer BFL and the first insulating layer GI1. The semiconductor layer ACT may include the seventh semiconductor pattern ACT_T7 constituting the seventh transistor T7. The seventh semiconductor pattern ACT_T7 may include a first region contacting the first transistor electrode ET71, a second region contacting the second transistor electrode ET72, and a channel region positioned between the first and second regions. The seventh semiconductor pattern ACT_T7 of the seventh transistor T7 may be a semiconductor pattern including polysilicon. The channel region is, for example, a semiconductor pattern that is not doped with impurities, and may be an intrinsic semiconductor. The first region and the second region may be semiconductor patterns doped with impurities.

The first insulating layer GI1 may be located on the semiconductor layer ACT. The first insulating layer GI1 may be an inorganic insulating layer including an inorganic material. As an example, the first insulating layer GI1 may include the same material as the buffer layer BFL or may include one or more materials selected from the example materials of the buffer layer BFL. In some embodiments, the first insulating layer GI1 may include an organic insulating layer including an organic material. The first insulating layer GI1 may be provided as a single layer, or may be provided as a multilayer of at least a double layer.

The first conductive layer GAT1 may be located on the first insulating layer GI1. As described with reference to FIG. 6A, the first conductive layer GAT1 may include the gate pattern T7_GE of the seventh transistor T7.

The second insulating layer GI2 may be located on the first insulating layer GI1 and the first conductive layer GAT1. The second insulating layer GI2 may be substantially formed over the entire surface of the base layer SUB. The second insulating layer GI2 may include the same material as the first insulating layer GI1, or may include one or more materials selected from the example materials of the first insulating layer GI1.

The second conductive layer GAT2 may be located on the second insulating layer GI2. As described with reference to FIG. 6A, the second conductive layer GAT2 may include a (1_1)th power line VL_VDD. The third insulating layer ILD may be located on the second insulating layer GI2 and the second conductive layer GAT2. The third insulating layer ILD may be substantially arranged over the entire surface of the base layer SUB. As an example, the third insulating layer ILD may include the same material as the buffer layer BFL or may include one or more materials selected from the example materials of the buffer layer BFL. The third insulating layer ILD may be a single layer or a multilayer layer including stack layers of different materials.

The third conductive layer SD1 may be located on the third insulating layer ILD. As described with reference to FIG. 6A, the third conductive layer SD1 may include the fifth bridge pattern BRP5 and the fifth power line VL_aint.

The fifth power line VL_aint may overlap one region of the seventh semiconductor pattern ACT_T7, may be connected to one region of the seventh semiconductor pattern ACT_T7 through a contact hole passing through the first insulating layer GI1, the second insulating layer GI2, and the third insulating layer ILD, and may configure the first transistor electrode ET71 of the seventh transistor T7.

The fifth bridge pattern BRP5 may overlap another region of the seventh semiconductor pattern ACT_T7, may be connected to another region of the seventh semiconductor pattern ACT_T7 through a contact hole passing through the first insulating layer GI1, the second insulating layer GI2, and the third insulating layer ILD, and may configure the second transistor electrode ET72 of the seventh transistor T7.

The first organic layer VIA1 may be located on the third insulating layer ILD and the third conductive layer SD1. The first organic layer VIA1 may be substantially arranged over the entire surface of the base layer SUB.

The first organic layer VIA1 may include an organic insulating material such as polyacrylates resin, epoxy resin, phenolic resin, polyamides resin, polyimides rein, unsaturated polyesters resin, poly phenylenethers resin, polyphenylenesulfides resin, or benzocyclobutene (BCB).

The fourth conductive layer SD2 may be located on the first organic layer VIA1. The fourth conductive layer SD2 may include a sixth bridge pattern BRP6 as described with reference to FIG. 6A.

The sixth bridge pattern BRP6 may overlap the fifth bridge pattern BRP5 and may be connected to the fifth bridge pattern BRP5 through a contact hole passing through the first organic layer VIA1.

The second organic layer VIA2 may be located on the first organic layer VIA1 and the fourth conductive layer SD2. The second organic layer VIA2 may be substantially arranged over the entire surface of the base layer SUB. The second organic layer VIA2 may include the same material as the first organic layer VIA1 or may include one or more materials selected from the example materials of the first organic layer VIA1.

A display element layer DPL may be provided on the second organic layer VIA2.

The display element layer DPL may include an anode AD, a pixel defining layer PDL, an emission layer EML, and a cathode CD. The anode AD, the pixel defining layer PDL, the emission layer EML, and the cathode CD may be sequentially arranged or formed on the second organic layer VIA2 (or the pixel circuit layer PCL).

The anode AD may be located on the second organic layer VIA2. The anode AD may be arranged to correspond to the emission area EA of each pixel.

The anode AD may be connected to the sixth bridge pattern BRP6 through a contact hole passing through the second organic layer VIA2 to expose the sixth bridge pattern BRP6. The anode AD may be connected to the second transistor electrode ET72 of the seventh transistor T7 through the sixth bridge pattern BRP6 and the fifth bridge pattern BRP5.

The anode AD may include a conductive material (or material) having a constant reflectance. The conductive material (or material) may include an opaque metal. Examples of the opaque metal may include a metal such as silver (Ag), magnesium (Mg), aluminium (Al), platinum (Pt), palladium (Pd), gold (Au), nickel (Ni), neodymium (Nd), iridium (Ir), chromium (Cr), titanium (Ti), molybdenum (Mo), or any alloy thereof. According to some embodiments, the anode AD may include a transparent conductive material. Examples of the transparent conductive material may include a conductive oxide such as indium tin oxide (ITO), indium zinc oxide (IZO), zinc oxide (ZnO), indium gallium zinc oxide (IGZO), or indium tin zinc oxide (ITZO), or a conductive polymer such as poly(3,4-ethylenedioxythiophene (PEDOT).

The pixel defining layer PDL may be arranged or formed on the second organic layer VIA2 and the anode AD in the non-emission area NEA. The pixel defining layer PDL may partially overlap the edge of the anode AD in the non-emission area NEA. The pixel defining layer PDL may include an insulating material including an inorganic material and/or an organic material. For example, the pixel defining layer PDL may include at least one inorganic layer including various currently known inorganic insulating materials including silicon nitride (SiNx) or silicon oxide (SiOx). Alternatively, the pixel defining layer PDL may include at least one organic layer and/or a photoresist layer including various currently known organic insulating materials, or may include a single-layer or multi-layer insulator including an organic/inorganic material in combination. That is, the material of the pixel defining layer PDL may be variously changed.

According to some embodiments, the pixel defining layer PDL may include at least one light blocking material and/or a reflective material to prevent a light leakage defect in which light leaks between pixels. In some embodiments, the pixel defining layer PDL may include a transparent material. Examples of the transparent material may include polyamides resin, polyimides resin, and the like, but the present invention is not limited thereto. According to some embodiments, a reflective material layer may be separately provided and/or formed on the pixel defining layer PDL so as to further improve the efficiency of light emitted from each pixel.

The emission layer EML may be located on the anode AD in the emission area EA. That is, the emission layer EML may be formed separately in each of the plurality of pixels PX. The emission layer EML may include an organic material and/or an inorganic material to emit a color (e.g., a set or predetermined color). For example, the pixel PX may include first to third sub-pixels. The first to third sub-pixels may emit red light, green light, and blue light, respectively.

However, the present invention is not limited thereto. For example, the emission layer EML may be commonly located on the plurality of pixels PX. In this case, the emission layer EML may emit white light.

The cathode CD may be located on the emission layer EML. The cathode CD may be commonly arranged in the plurality of pixels PX.

The thin film encapsulation layer TFE may be located on the cathode CD. The thin film encapsulation layer TFE may be commonly located on the plurality of pixels PX. FIG. 7 illustrates that the thin film encapsulation layer (TFE) directly covers the cathode (CD), but a capping layer covering the cathode CD may be further located between the thin film encapsulation layer TFE and the cathode CD.

Hereinafter, differences between the stack structure of the buffer layer BFL through the first transistor T1 area and the third transistor T3 area will be mainly described.

The first transistor T1 may include a first semiconductor pattern ACT_T1, a first transistor electrode ET11, a second transistor electrode ET12, and a gate pattern T1_GE, and the third transistor T3 may include a third semiconductor pattern ACT_T3, a first transistor electrode ET31, a second transistor electrode ET32, and a gate pattern T3_GE. In this case, the arrangement of the first semiconductor pattern ACT_T1, the first transistor electrode ET11, the second transistor electrode ET12, and the gate pattern T1_GE of the first transistor T1 and the arrangement of the third semiconductor pattern ACT_T3, the first transistor electrode ET31, the second transistor electrode ET32, and the gate pattern T3_GE of the third transistor T3 are substantially the same as the arrangement of the seventh semiconductor pattern ACT_T7, the first transistor electrode ET71, the second transistor electrode ET72, and the gate pattern T7_GE of the seventh transistor T7. Therefore, redundant descriptions thereof will be omitted.

The first semiconductor pattern ACT_T1 may include a first region contacting the first transistor electrode ET11, a second region contacting the second transistor electrode ET12, and a channel region located between the first and second regions. The first semiconductor pattern ACT_T1 of the first transistor T1 may be a semiconductor pattern including polysilicon.

Only the second buffer layer BFL2 including silicon oxide SiOx may be located below the first semiconductor pattern ACT_T1. In other words, the first buffer layer BFL1 including silicon nitride (SiNx) may not be located between the first semiconductor pattern ACT_T1 and the barrier layer BRL.

Silicon nitride (SiNx) may include impurities. For example, silicon nitride (SiNx) may include hydrogen. Therefore, when the first buffer layer BFL1 including silicon nitride (SiNx) is located under the first semiconductor pattern ACT_T1, hydrogen included in silicon nitride (SiNx) may be diffused and doped into the first semiconductor pattern ACT_T1 during a heat treatment process.

When hydrogen is diffused and doped into the first semiconductor pattern ACT_T1, grain defect of the first semiconductor pattern ACT_T1 may be reduced. Due to this, although the leakage current is reduced, there may be a problem in that the driving range (DR range) of the gate voltage applied to the gate electrode of the first transistor T1 (or the driving transistor) also decreases. When the grain defect of the first semiconductor pattern ACT_T1 is reduced, even a slight change in the gate voltage applied to the gate electrode of the first transistor T1 (or the driving transistor) may cause the luminance of the light emitting device LD to be immediately changed, making it difficult to express various grayscales.

Referring to FIG. 8, it is assumed that all transistors included in the pixel are formed through the same process. For example, the stack structure and thickness of the buffer layer BFL located under the first transistor T1 (or the driving transistor) and the third transistor T3 (or the switching transistor) may be the same.

Test group A is a reference, and the leakage current Ioff of the third transistor T3 is about 10 [fA], and the driving range of the first transistor T1 is about 3 [V]. According to some embodiments, in order to improve the leakage current (Ioff) characteristics of the transistor, an excimer laser heat treatment method may be used. In this case, the energy density when irradiating the excimer laser to the semiconductor pattern generally increases from test group B to test group H, and other conditions may be changed. Due to this, it was experimentally confirmed that the leakage current Ioff of the third transistor T3 decreased from about 9.74 [fA] to about 1.23 [fA]. In particular, in test group H, when hydrogen was injected into the semiconductor pattern through plasma treatment as other conditions, it was confirmed that the leakage current (Ioff) characteristics were further improved compared to other test groups. On the other hand, it can be seen that the driving range (DR range) of the first transistor T1 decreases from about 2.94 [V] to about 1.89 [V] from test group B to test group H. That is, when the process of improving the leakage current (Ioff) characteristics of the third transistor T3 is performed, there occurs a problem in that the driving range (DR range) characteristics of the first transistor T1 are reduced. Therefore, the first transistor T1 requiring good DR range characteristics and the third transistor T3 requiring good leakage current (Ioff) characteristics are required to be formed in separate processes.

Therefore, by not arranging the first buffer layer BFL1 including silicon nitride (SiNx) under the first semiconductor pattern ACT_T1 of the first transistor T1 (or the driving transistor), diffusion of hydrogen into the first semiconductor pattern ACT_T1 may be prevented. Due to this, the driving range (DR range) of the gate voltage applied to the gate electrode of the first transistor T1 may have a wide range. That is, by varying the magnitude of the gate voltage applied to the gate electrode of the first transistor T1, the light emitted from the light emitting element LD may be controlled to have a richer grayscale.

The second buffer layer BFL2 located under the first semiconductor pattern ACT_T1 of the first transistor T1 may be formed to a first thickness d1 sufficient to prevent diffusion of impurity ions and prevent penetration of moisture or external air. For example, the first thickness d1 may be about 3,500 Å.

The third semiconductor pattern ACT_T3 may include a first region contacting the third transistor electrode ET31, a second region contacting the third transistor electrode ET32, and a channel region positioned between the first region and the second region. The first semiconductor pattern ACT_T3 of the third transistor T3 may be a semiconductor pattern including polysilicon.

Both the first buffer layer BFL1 including silicon nitride (SiNx) and the second buffer layer BFL2 including silicon oxide (SiOx) may be located below the third semiconductor pattern ACT_T3 (or the switching transistor). In other words, the first buffer layer BFL1 including silicon nitride (SiNx) may be located between the third semiconductor pattern ACT_T3 and the barrier layer BRL.

As described above, silicon nitride (SiNx) may include hydrogen. Therefore, when the first buffer layer BFL1 including silicon nitride (SiNx) is located under the third semiconductor pattern ACT_T3, hydrogen included in silicon nitride (SiNx) may be diffused and doped into the third semiconductor pattern ACT_T3 during the heat treatment process. When hydrogen is diffused and doped into the third semiconductor pattern ACT_T3, grain defect of the third semiconductor pattern ACT_T3 is reduced. Therefore, an effect of reducing a leakage current may be expected.

When one electrode of the third transistor T3 is connected to the gate electrode of the first transistor T1 (or the driving transistor) and thus the leakage current occurs, a voltage applied to the gate electrode of the first transistor T1 may change. For example, when the amount of leakage current generated in the third transistor T3 increases, the voltage applied to the gate electrode of the first transistor T1 may increases, so that the gate-source voltage of the first transistor T1 may decrease. In this case, because the driving current flowing through the first transistor T1 decreases, the luminance of the light emitting element LD may decrease. That is, when the leakage current occurs in the third transistor T3, a flicker phenomenon in which the luminance of the light emitting element LD is periodically changed may be observed. In particular, when the display device (see 1000 of FIG. 1) is driven at a low frequency, the flicker phenomenon may be more problematic.

Therefore, like the third transistor T3, the transistor connected to the gate electrode of the first transistor T1 (or the driving transistor) is required to have a minimum leakage current.

On the other hand, when hydrogen is diffused and doped into the third semiconductor pattern ACT_T3, the driving range (DR range) of the gate voltage applied to the gate electrode of the third transistor T3 also decreases as described above. However, because the third transistor T3 is a switching transistor in which leakage current characteristics are more important than driving range characteristics, it may be beneficial to form the first buffer layer BFL1 including silicon nitride (SiNx) under the third semiconductor pattern ACT_T3 of the third transistor T3.

The first buffer layer BFL1 located under the third semiconductor pattern ACT_T3 of the third transistor T3 may be formed to a thickness d0 so that hydrogen can be sufficiently supplied to the third semiconductor pattern ACT_T3 to reduce the leakage current to a preset level. For example, the thickness d0 may be about 500 Å. In addition, the second buffer layer BFL2 located under the third semiconductor pattern ACT_T3 of the third transistor T3 may be formed to a second thickness d2 that is substantially equal to the first thickness d1 of the second buffer layer BFL2 located under the first semiconductor pattern ACT_T1 of the first transistor T1. For example, the second thickness d2 may be about 3,500 Å.

Although only the third transistor T3 is illustrated in FIG. 7, the second transistor T2, the fourth transistor T4, and the fifth transistor T5 that affect the gate electrode of the first transistor T1 based on the pixel PX of FIG. 2 are also required to have a minimum leakage current like third transistor T3. In this case, the third transistor T3 and the fourth transistor T4 may be directly connected to the gate electrode of the first transistor T1 (or the first node N1), and the second transistor T2 and the fifth transistor may be indirectly connected to the gate electrode of the first transistor T1 (or the first node N1) via the first capacitor C1.

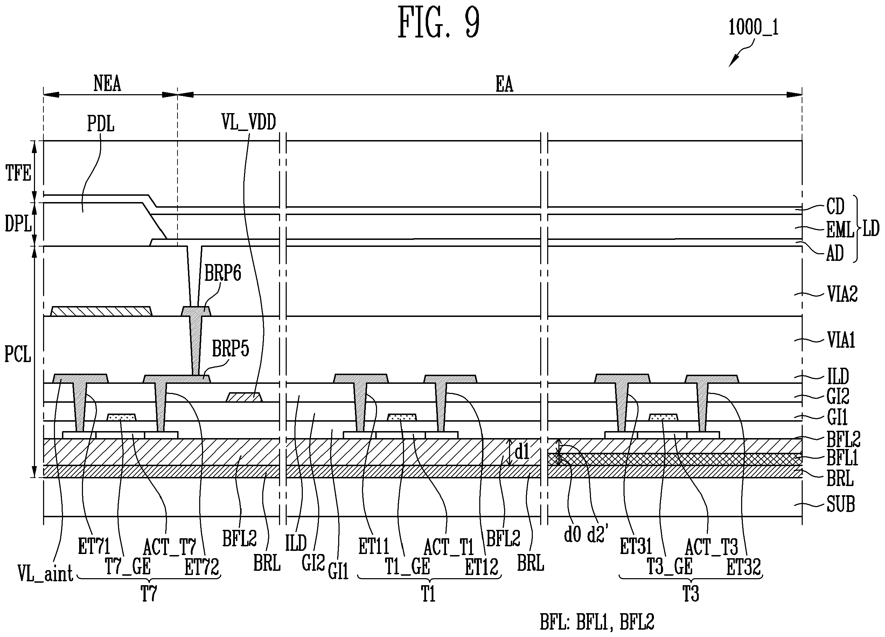

FIG. 9 is a partial cross-sectional view for describing the stack structure of the first transistor area, the third transistor area, and the seventh transistor area of FIG. 6A according to some embodiments.

According to some embodiments described with respect to FIG. 9, a second thickness d2' of the second buffer layer BFL2 located under the third semiconductor pattern ACT_T3 of the third transistor T3 is different from a first thickness d1 of the second buffer layer BFL2 located under the first semiconductor pattern ACT_T1 of the first transistor T1. Therefore, the embodiments described with respect to FIG. 9 differ from the embodiments described with respect to FIG. 7 in which the second thickness d2 of the second buffer layer BFL2 located under the third semiconductor pattern ACT_T3 of the third transistor T3 is substantially equal to the first thickness d1 of the second buffer layer BFL2 located under the first semiconductor pattern ACT_T1 of the first transistor T1. The remaining configurations illustrated in FIG. 9 are substantially the same as the remaining configurations illustrated in FIG. 7.

The second thickness d2' of the second buffer layer BFL2 located under the third semiconductor pattern ACT_T3 of the third transistor T3 according to some embodiments may be formed so that the height of the upper surface of the second buffer layer BFL2 located under the third transistor T3 is equal to the height of the upper surface of the second buffer layer BFL2 located under the first transistor T1. In other words, the sum of the thickness d0 of the first buffer layer BFL1 located under the third semiconductor pattern ACT_T3 of the third transistor T3 and the second thickness d2' of the second buffer layer BFL2 may be substantially equal to the first thickness d1 of the second buffer layer BFL2 located under the first semiconductor pattern ACT_T1 of the first transistor T1.

In this case, due to the smaller second thickness d2' of the second buffer layer BFL2 located under the third semiconductor pattern ACT_T3 of the third transistor T3, more hydrogen may flow into the third semiconductor pattern ACT_T3 from the first buffer layer BFL1 during the heat treatment process, and the formation heights of the transistors (e.g., T1 to T9) formed on the display panel (see 100 of FIG. 1) coincide with each other, thereby reducing the process error.

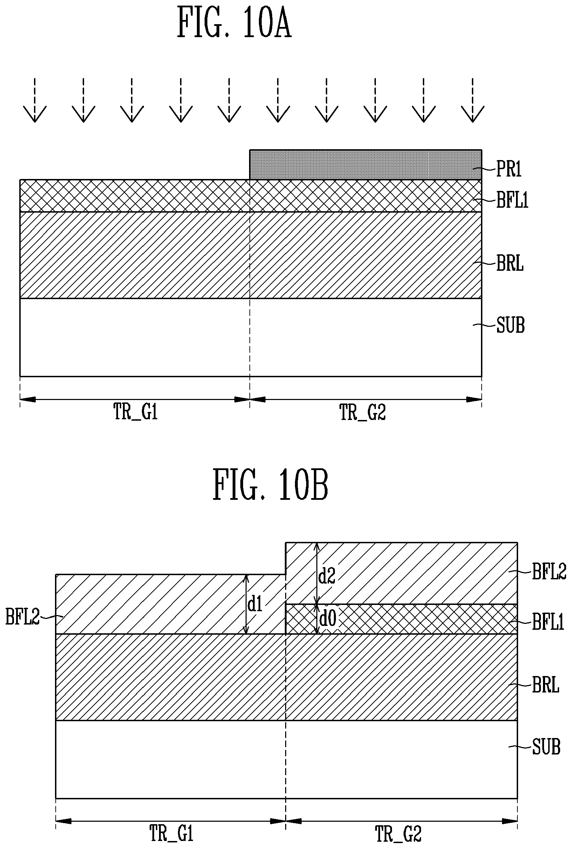

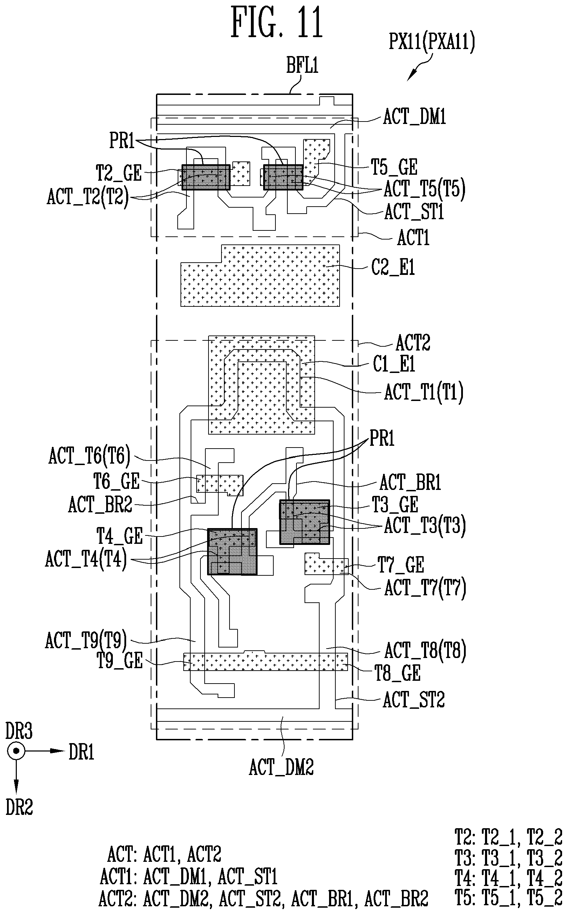

FIGS. 10A to 10C are diagrams for describing a method of forming a buffer layer in the embodiments of FIGS. 7 and 9. FIG. 11 is a schematic plan view for describing a position of a photoresist pattern.

Referring to FIGS. 7 to 10A, the pixel according to some embodiments may be formed by sequentially stacking a pixel circuit layer PCL, a display element layer DPL, and a thin film encapsulation layer TFE on a base layer SUB (or a substrate).

Hereinafter, the process of forming the buffer layer BFL in the process of forming the pixel circuit layer PCL will be mainly described. In this case, the first transistor group TR_G1 may include transistors requiring driving range (DR range) characteristics, and the second transistor group TR_G2 may include transistors requiring leakage current characteristics more than the driving range characteristics. For example, based on the pixel PX illustrated in FIG. 2, the first transistor group TR_G1 may include a first transistor T1 and sixth to ninth transistors T6 to T9, and the second transistor group TR_G2 may include second to fifth transistors T2 to T5.

First, the step of preparing the base layer SUB (or the substrate) and cleaning the base layer SUB may be included. The base layer SUB is cleaned in order to remove impurities such as a residual film, metal, and transparent conductive metal positioned on the base layer SUB. This is referred to as a substrate cleaning step.

Next, the step of depositing a barrier layer BRL on the base layer SUB may be included. The barrier layer BRL may be located on the entire surface of the base layer SUB. That is, the first transistor group TR_R1 and the second transistor group TR_R2 may be formed on the entire surface of the base layer SUB without distinction. The barrier layer BRL blocks unnecessary components such as moisture or oxygen from flowing into the light emitting element from the outside. For example, the barrier layer BRL may include silicon dioxide (SiO₂). The thickness of the barrier layer BRL may be about 5,000 Å.

Next, the step of depositing a first buffer layer BFL1 on the barrier layer BRL may be included. The first buffer layer BFL1 may be located on the entire surface of the base layer SUB. The first buffer layer BFL1 may include nitrogen oxide (SiNx). The thickness d0 of the first buffer layer BFL1 may be about 500 Å.

Next, a photoresist layer may be formed by using a solution coating method such as spin coating on the photoresist. After a first mask is located on the photoresist layer, an exposure process of irradiating ultraviolet (UV) rays may be performed thereon. A developing process of applying a liquid developer to the exposed photoresist layer and removing the exposed photoresist layer is performed to form a first photoresist pattern PR1. The first photoresist pattern PR1 may be located in a region corresponding to the second transistor group TR_G2.

Referring to FIG. 11, in a plan view, the first photoresist pattern PR1 is illustrated as being formed in a rectangular shape so as to overlap the semiconductor patterns (e.g., ACT_T2, ACT_T3, ACT_T4, and ACT_T5) of the transistors (e.g., T2 to T5) included in the second transistor group TR_G2 in the thickness direction. However, the present invention is not limited thereto, and the first photoresist pattern PR1 may be variously modified into a shape and size sufficient to supply hydrogen to the semiconductor patterns (e.g., ACT_T2, ACT_T3, ACT_T4, and ACT_T5).

At this time, the photoresist material may be divided into a positive type and a negative type. The positive type has a mechanism in which the portion irradiated with UV is removed by the developer, and the negative type has a mechanism in which the portion irradiated with UV is not removed by the developer and the portion not irradiated with UV is removed. According to some embodiments, the positive-type photoresist is described as an example, but the negative-type photoresist may also be used.

Next, the first buffer layer BFL1 exposed by the first photoresist pattern PR1 is removed by dry etching, so that the first buffer layer BFL1 is located only in the region corresponding to the second transistor group TR_G2. The first photoresist pattern PR1 remaining on the first buffer layer BFL1 in the region corresponding to the second transistor group TR_G2 may be stripped.

Next, referring to FIG. 10B, the step of depositing a second buffer layer BFL2 on the barrier layer BRL and the first buffer layer BFL1 may be included. That is, the second buffer layer BFL2 may be formed on the entire surface of the base layer SUB. The second buffer layer BFL2 may include silicon oxide (SiOx). The thicknesses d1 and d2 of the second buffer layer BFL2 may be about 3,500 Å.

In this case, the stack structure of FIG. 10B may correspond to the embodiments described with respect to FIG. 7. In the embodiments described with respect to FIG. 10B, after the second buffer layer BFL2 is deposited, a separate polishing process to be described in more detail below may be omitted. Therefore, because the process steps may be reduced, the effect of reducing process time and process deviation may be expected. That is, according to some embodiments, various processing operations (e.g., a polishing process) may be omitted, which may improve the processing time and cost, and may improve the efficiency of the manufacturing process.

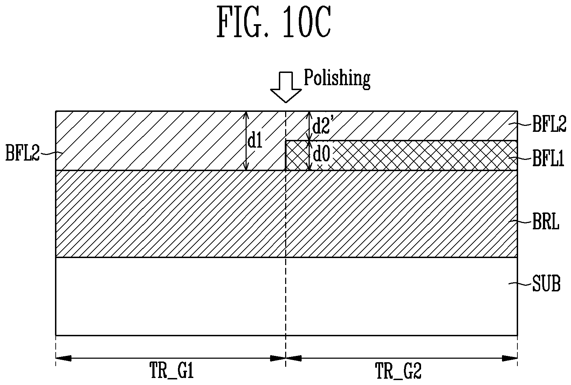

The stack structure of FIG. 10C may correspond to the embodiments described with respect to FIG. 9. The polishing process may be performed on the second buffer layer BFL2 after the process of FIG. 10B and before the formation of the semiconductor pattern. For example, the height of the upper surface of the second buffer layer BFL2 may be the same in the region corresponding to the first transistor group TR_G1 and the region corresponding to the second transistor group TR_G2 through chemical mechanical polishing (CMP). In this case, in the region corresponding to the second transistor group TR_G2, due to the smaller second thickness d2' of the second buffer layer BFL2, more hydrogen may flow into the semiconductor patterns (e.g., ACT_T2, ACT_T3, ACT_T4, and ACT_T4) from the first buffer layer BFL1 during the heat treatment process, and the process error may be reduced.

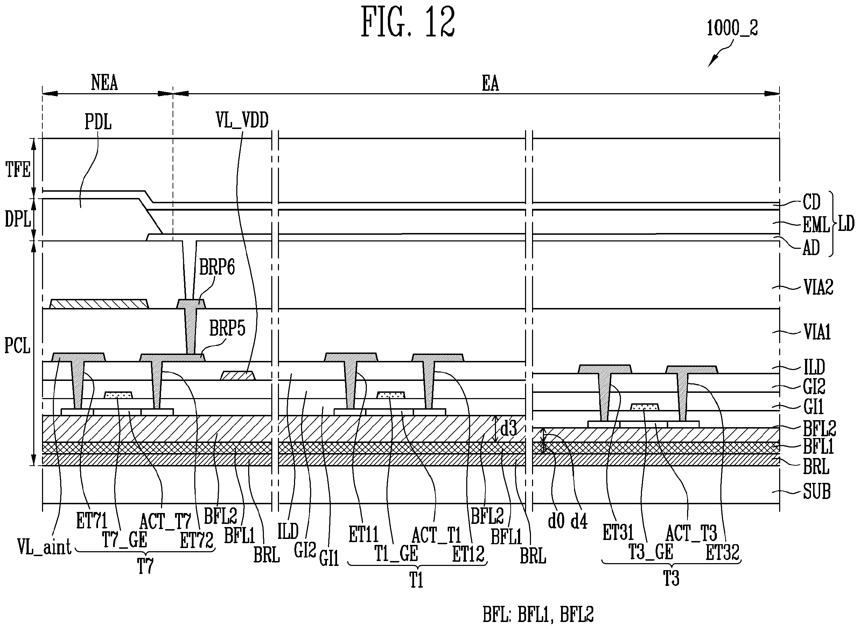

FIG. 12 is a partial cross-sectional view for describing a stack structure of a first transistor area, a third transistor area, and a seventh transistor area of FIG. 6A according to some embodiments.

In the embodiments described with respect to FIG. 12, a first buffer layer BFL1 is formed on an entire surface of a base layer SUB, and a thickness of a second buffer layer BFL2 located under a first semiconductor pattern ACT_T1 of a first transistor T1 is different from a thickness of a second buffer layer BFL2 located under a third semiconductor pattern ACT_T3 of a third transistor T3. Therefore, the embodiments described with respect to FIG. 12 differs from the embodiments described with respect to FIG. 7 in which the first buffer layer BFL1 is formed only under the third semiconductor pattern ACT_T3 of the third transistor T3, and the thickness of the second buffer layer BFL2 located under the first semiconductor pattern ACT_T1 of the first transistor T1 is equal to the thickness of the second buffer layer BFL2 located under the third semiconductor pattern ACT_T3 of the third transistor T3. The remaining configurations illustrated in FIG. 12 are substantially the same as the remaining configurations illustrated in FIG. 7.

Referring to FIG. 12, in the first transistor T1 (or the driving transistor), both a first buffer layer BFL1 including silicon nitride (SiNx) and a second buffer layer BFL2 including silicon oxide (SiOx) may be located under the first semiconductor pattern ACT_T1. In other words, the first buffer layer BFL1 including silicon nitride (SiNx) may be located between the first semiconductor pattern ACT_T1 and the barrier layer BRL.

In addition, even in the third transistor T3 (or the switching transistor), both the first buffer layer BFL1 including silicon nitride (SiNx) and the second buffer layer BFL2 including silicon oxide (SiOx) may be located below the third semiconductor pattern ACT_T3 (or the switching transistor). In other words, the first buffer layer BFL1 including silicon nitride (SiNx) may be located between the third semiconductor pattern ACT_T3 and the barrier layer BRL.

However, a third thickness d3 of the second buffer layer BFL2 located under the first transistor T1 may be different from a fourth thickness d4 of the second buffer layer BFL2 located under the third transistor T3. According to some embodiments, the third thickness d3 may be greater than the fourth thickness d4. For example, the third thickness d3 may be 4,000 Å. In this case, the third thickness d3 may be greater than the first thickness d1 illustrated in FIG. 10B.

Due to this, the third thickness d3 of the second buffer layer BFL2 located under the first transistor T1 is greater than the fourth thickness d3 of the second buffer layer BFL2 located under the third transistor T3. Thus, the amount of hydrogen flowing into the first semiconductor pattern ACT_T1 from the first buffer layer BFL1 located under the first transistor T1 may be smaller than the amount of hydrogen flowing into the third semiconductor pattern ACT_T3 from the first buffer layer BFL1 located under the third transistor T3. That is, the embodiments illustrated with respect to FIG. 12 may also expect substantially the same effect as the embodiments illustrated in FIGS. 7 and 9.

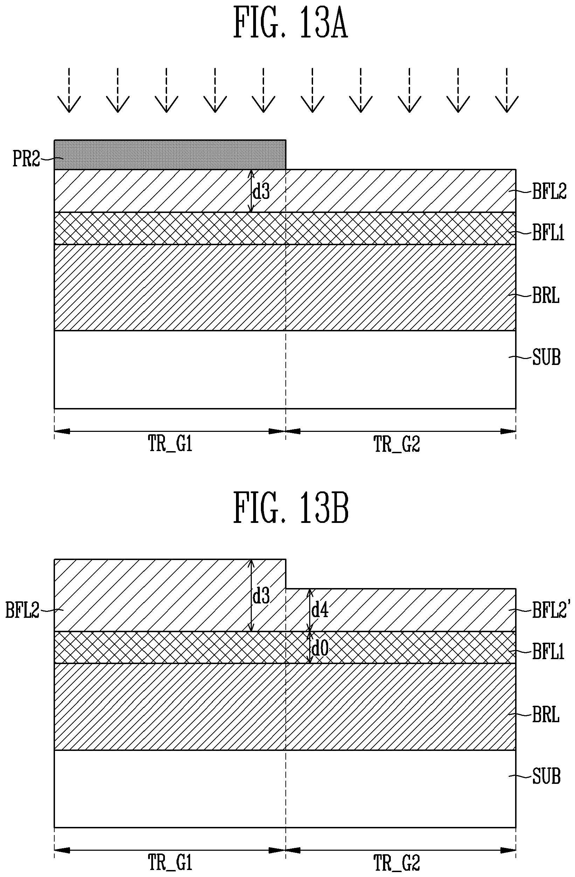

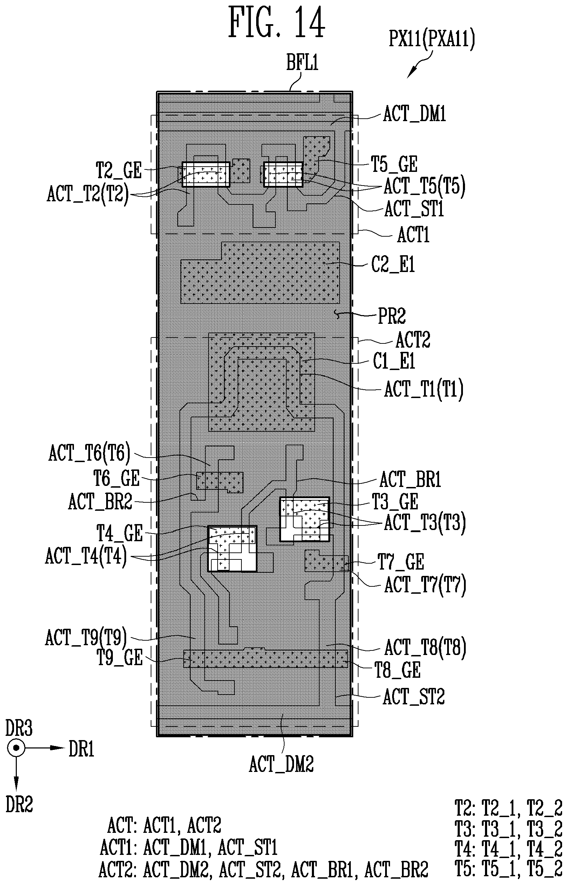

FIGS. 13A and 13B are diagrams for describing a method of forming a buffer layer in the embodiments illustrated with respect to FIG. 12. FIG. 14 is a schematic plan view for describing a position of a photoresist pattern.

Referring to FIGS. 12 to 14, the pixel according to some embodiments may be formed by sequentially stacking a pixel circuit layer PCL, a display element layer DPL, and a thin film encapsulation layer TFE on a base layer SUB (or a substrate).

Hereinafter, the process of forming the buffer layer BFL in the process of forming the pixel circuit layer PCL will be mainly described. In this case, the first transistor group TR_G1 may include transistors requiring driving range (DR range) characteristics, and the second transistor group TR_G2 may include transistors requiring leakage current characteristics more than the driving range characteristics. For example, based on the pixel PX illustrated in FIG. 2, the first transistor group TR_G1 may include a first transistor T1 and sixth to ninth transistors T6 to T9, and the second transistor group TR_G2 may include second to fifth transistors T2 to T5.

First, the step of preparing the base layer SUB (or the substrate) and cleaning the base layer SUB may be included.

Next, the step of depositing a barrier layer BRL on the base layer SUB may be included. The barrier layer BRL may be formed on the entire surface of the base layer SUB. That is, the first transistor group TR_R1 and the second transistor group TR_R2 may be formed on the entire surface of the base layer SUB without distinction. The thickness d0 of the barrier layer BRL may be 5,000 Å.

Next, the step of depositing a first buffer layer BFL1 on the barrier layer BRL may be included. The first buffer layer BFL1 may be formed on the entire surface of the base layer SUB. The first buffer layer BFL1 may include nitrogen oxide (SiNx). The thickness d0 of the first buffer layer BFL1 may be about 500 Å.

Next, the step of depositing a second buffer layer BFL2 on the first buffer layer BFL1 may be included. That is, the second buffer layer BFL2 may be formed on the entire surface of the base layer SUB (or the first buffer layer BFL1). The second buffer layer BFL2 may include silicon oxide (SiOx). For example, the third thickness d3 of the second buffer layer BFL2 may be about 4,000 Å, and the fourth thickness d4 of the second buffer layer BFL2 may be about 3,000 Å to 3,500 Å.

Next, a photoresist layer may be formed by using a solution coating method such as spin coating on the photoresist. After a second mask is arranged on the photoresist layer, an exposure process of irradiating ultraviolet (UV) rays may be performed thereon. A developing process of applying a liquid developer to the exposed photoresist layer and removing the exposed photoresist layer is performed to form a second photoresist pattern PR2. Contrary to the first photoresist pattern PR1, the second photoresist pattern PR2 may be located in a region corresponding to the first transistor group TR_G1.

Referring to FIG. 14, in a plan view, the second photoresist pattern PR2 is illustrated as being formed in a pixel (PX) area except for a rectangular shape so as to overlap the semiconductor patterns (e.g., ACT_T2, ACT_T3, ACT_T4, and ACT_T5) of the transistors (e.g., T2 to T5) included in the second transistor group TR_G2 in the thickness direction.

Next, the second buffer layer BFL2 exposed by the second photoresist pattern PR2 is partially removed by dry etching, so that the second buffer layer BFL2' in the region corresponding to the second transistor group TR_G2 is formed to a fourth thickness d4 that is less than a third thickness d3 of the second buffer layer BFL2 in the region corresponding to the first transistor group TR_G1 as illustrated in FIG. 13B. For example, the third thickness d3 of the second buffer layer BFL2 may be about 4,000 Å, and the fourth thickness d4 of the second buffer layer BFL2' may be about 3,000 Å to 3,500 Å.

In this case, the second mask may be a half mask. In addition, the second photoresist pattern PR2 remaining on the second buffer layer BFL2 may be stripped.

Due to this, the embodiments illustrated with respect to FIG. 12 may have substantially the same effect as the embodiments illustrated with respect to FIGS. 7 and 9. Because the first buffer layer BFL1 is further included under the first transistor group TR_G1, the effect of preventing the diffusion of impurity ions and preventing infiltration of moisture or external air may be more excellent.

Although the present invention has been described with reference to the embodiments, it will be understood by those skilled in the art that various modifications and changes can be made thereto without departing from the spirit and scope of the present invention as set forth in the appended claims, and their equivalents.

## Claims

1. A display device comprising:
a substrate;
a buffer layer on the substrate;
a driving transistor on the buffer layer and including a first semiconductor pattern, a first gate electrode, a first source electrode, and a first drain electrode; and
a switching transistor on the buffer layer and spaced apart from the driving transistor, the switching transistor including a second semiconductor pattern, a second gate electrode, a second source electrode, and a second drain electrode,
wherein the buffer layer includes a first buffer layer including silicon nitride and a second buffer layer including silicon oxide,
only the second buffer layer is under the first semiconductor pattern of the driving transistor, and
the first buffer layer and the second buffer layer are under the second semiconductor pattern of the switching transistor.

2. The display device of claim 1, wherein the first semiconductor pattern and the second semiconductor pattern include polysilicon.

3. The display device of claim 1, wherein a hydrogen ion concentration included in the second semiconductor pattern is greater than a hydrogen ion concentration included in the first semiconductor pattern.

4. The display device of claim 1, wherein a first thickness of the second buffer layer under the first semiconductor pattern is equal to a second thickness of the second buffer layer under the second semiconductor pattern.

5. The display device of claim 4, wherein a third thickness of the first buffer layer under the second semiconductor pattern is less than the second thickness.

6. The display device of claim 1, wherein a first thickness of the second buffer layer under the first semiconductor pattern is equal to a sum of a second thickness of the second buffer layer under the second semiconductor pattern and a third thickness of the first buffer layer under the second semiconductor pattern.

7. The display device of claim 1, further comprising a barrier layer including silicon oxide between the substrate and the buffer layer.

8. The display device of claim 7, wherein the first buffer layer is on the barrier layer, and the second buffer layer is on the first buffer layer.

9. The display device of claim 1, wherein a plurality of pixels are on the substrate, and
each of the pixels includes:
a light emitting element;
the driving transistor connected between a first power supply and a second node and controlling a driving current supplied to the light emitting element in response to a voltage of a first node connected to the first gate electrode;
a first capacitor including one electrode connected to the first node and the other electrode connected to a third node;
a second transistor connected between the third node and a data line and turned on by a first scan signal;
a third transistor connected between the first node and the second node and turned on by a second scan signal;
a fourth transistor connected between the first node and an initialization power supply and turned on by a third scan signal; and
a fifth transistor connected between a reference power supply and the third node and turned on by the second scan signal.

10. The display device of claim 9, wherein the second transistor includes a (2_1)th transistor and a (2_2)th transistor connected in series,
the third transistor includes a (3_1)th transistor and a (3_2)th transistor connected in series,
the fourth transistor includes a (4_1)th transistor and a (4_2)th transistor connected in series, and
the fifth transistor includes a (5_1)th transistor and a (5_2)th transistor connected in series.

11. The display device of claim 9, wherein the switching transistor includes the second transistor, the third transistor, the fourth transistor, and the fifth transistor.

12. The display device of claim 9, further comprising:
a sixth transistor connected between the first power supply and a fifth node connected to one electrode of the driving transistor and turned on by a first emission control signal;
a seventh transistor connected between the second node and a fourth node and turned on by a second emission control signal;
an eighth transistor connected between the fourth node and an anode initialization power supply and turned on by a fourth scan signal; and
a ninth transistor connected between the fifth node and a bias power supply and turned on by the fourth scan signal.

13. The display device of claim 9, further comprising a second capacitor including one electrode connected to the first power supply and the other electrode connected to the third node.

14. A display device comprising:
a substrate;
a buffer layer on the substrate;
a driving transistor on the buffer layer and including a first semiconductor pattern, a first gate electrode, a first source electrode, and a first drain electrode; and
a switching transistor on the buffer layer and spaced apart from the driving transistor, the switching transistor including a second semiconductor pattern, a second gate electrode, a second source electrode, and a second drain electrode,
wherein the buffer layer includes a first buffer layer including silicon nitride and a second buffer layer including silicon oxide,
the first buffer layer and the second buffer layer are under the first semiconductor pattern of the driving transistor,
the first buffer layer and the second buffer layer are under the second semiconductor pattern of the switching transistor, and
a first thickness of the second buffer layer under the first semiconductor pattern is greater than a second thickness of the second buffer layer under the second semiconductor pattern.

15. The display device of claim 14, wherein the first semiconductor pattern and the second semiconductor pattern include polysilicon.

16. The display device of claim 14, wherein a hydrogen ion concentration included in the second semiconductor pattern is greater than a hydrogen ion concentration included in the first semiconductor pattern.

17. The display device of claim 14, wherein a third thickness of the first buffer layer is less than the first thickness and the second thickness.

18. The display device of claim 17, further comprising a barrier layer including silicon oxide between the substrate and the buffer layer.

19. The display device of claim 18, wherein the first buffer layer is on the barrier layer, and the second buffer layer is on the first buffer layer.

20. The display device of claim 14, wherein the second drain electrode is electrically connected to the first gate electrode.
